(19) Europäisches Patentamt

European Patent Office

Office européen des brevets

(11) **EP 4 742 112 A1**

(12) **EUROPEAN PATENT APPLICATION**
published in accordance with Art. 153(4) EPC

(43) Date of publication:
**13.05.2026   Bulletin 2026/20**

(21) Application number: **23944490.4**

(22) Date of filing: **01.12.2023**

(51) International Patent Classification (IPC):
*G06N 10/40* (2022.01)        *H03K 3/80* (2006.01)
*B82Y 10/00* (2011.01)

(52) Cooperative Patent Classification (CPC):
**B82Y 10/00; G06N 10/40; H03K 3/80**

(86) International application number:
**PCT/KR2023/019671**

(87) International publication number:
**WO 2025/009674 (09.01.2025 Gazette 2025/02)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:   **03.07.2023   KR 20230085539**

(71) Applicant: **POSTECH Research and Business
Development
Foundation
Pohang-si, Gyeongsangbuk-do 37673 (KR)**

(72) Inventors:
• **SIM, Jae Yoon**
  **Pohang-si, Gyeongsangbuk-do 37673 (KR)**
• **KANG, Ki Seo**
  **Pohang-si Gyeongsangbuk-do 37673 (KR)**

(74) Representative: **Jung, Minkyu
Wuesthoff & Wuesthoff
Patentanwälte und Rechtsanwalt PartG mbB
Schweigerstraße 2
81541 München (DE)**

(54) **METHOD AND APPARATUS FOR GENERATING LOW-POWER QUBIT CONTROL SIGNAL FOR SUPERCONDUCTING QUANTUM COMPUTER CONTROL**

(57)    Disclosed are a method and an apparatus for generating a qubit control signal, wherein a main pulse and a DRAG pulse used to control a superconducting quantum computer are generated with low power and without a memory. The method comprises the steps of: generating a first sine curve having a first phase obtained by multiplying an angular velocity by a predetermined time of each period, the angular velocity being obtained by adding a first angular velocity of a center frequency and a second angular velocity at a predetermined time of each period; and generating a second sine curve having a second phase obtained by multiplying an angular velocity by a predetermined time, the angular velocity being obtained by subtracting the second angular velocity from the first angular velocity. The DRAG pulse is generated through an operation of adding the first sine curve and the second sine curve.

FIG. 8

EP 4 742 112 A1

**Description**

[Technical Field]

The present disclosure relates to a qubit control signal generation technology for a superconducting quantum computer, and more particularly, to a qubit control signal generation method and apparatus for generating a main pulse and a DRAG (derivative removal by adiabatic gate) pulse used in superconducting quantum computer control with low power consumption and without memory.

[Background Art]

A superconducting quantum computer is currently controlled using radio frequency (RF) signals and phase. A transmon qubit, which is the basic data processing unit of a superconducting quantum computer, has a shorter coherence time-i.e., the duration during which information is maintained-compared to other types of qubits. Google and IBM, which are currently developing superconducting quantum computers, are attempting to reduce the length of control signals in order to perform more operations within the limited coherence time.

A qubit, utilizing quantum characteristics, has a unique frequency corresponding to each energy state. The frequency used for basic quantum computing operations corresponds to the energy level of $|0> \leftrightarrow |1>$ state $\omega_{01}$, and the frequency used to create quantum entanglement corresponds to the energy level of $|1> \leftrightarrow |2>$ state $\omega_{12}$. Generally, the frequency $f_{01}$ corresponding to the ground state energy $\omega_{01}$ is between 5-7 GHz, and the frequency $f_{12}$ corresponding to the first excited state energy $\omega_{12}$ refers to a frequency approximately 150-350 MHz lower than the above frequency $f_{01}$.

When the length of the RF signal for qubit control is shortened, the frequency spectrum spreads more widely. This causes noise in the frequency region surrounding the center frequency of the qubit. That is, in consideration of the limited coherence time, for example, when a short pulse width of 30 ns or less is used, the frequency power spreads around the center frequency. This generates unwanted changes in energy state-i.e., noise-at a second frequency $f_{12}$ located approximately 150-350 MHz to the left of the center frequency $f_{01}$ of the qubit. This becomes a major source of error in quantum operations.

To address such sources of error and to minimize frequency spreading, techniques have been proposed that use pulse shapes such as a Gaussian shape, sine shape, or raised cosine shape instead of a rectangular pulse shape.

However, although the aforementioned conventional techniques may reduce frequency spreading compared to the rectangular shape, as the length of the control pulse becomes shorter, it becomes impossible to achieve sufficiently low noise at the second frequency using only the pulse shape.

Another conventional technique proposes a method to reduce noise at the second frequency by generating a DRAG (derivative removal by adiabatic gate) pulse with a 90° phase difference from the frequency of the main pulse, using the derivative shape of the original signal-i.e., the main pulse. This method is currently used in most superconducting quantum computer operations.

Although the method of generating a qubit control pulse using a DRAG pulse plays a significant role in reducing noise at the second frequency, the process of generating the DRAG pulse, which is a high-frequency signal with a 90° phase difference and a derivative pulse shape, significantly increases the complexity of the circuit.

In addition, the DRAG pulse is originally used in conjunction with the main pulse and functions to reduce the frequency power on the left side of the center frequency while increasing it on the right side. One of the other conventional techniques that utilizes this characteristic while addressing the drawbacks of the DRAG pulse involves a single sideband (SSB) synthesis method to control frequency and phase, and in the process, generates a pulse shape that reduces noise at the second frequency located to the left of the center frequency using memory.

However, the aforementioned conventional method requires a high digital system frequency, for example, 1 GHz or more, due to the characteristics of the qubit. Since high resolution is also required, a large number of bits is needed. In particular, to generate a Gaussian pulse shape and differentiated DRAG pulse shape thereof, memory is essential, and since each qubit has a unique frequency property, memory cannot be shared. Thus, a large amount of memory capable of storing values for each individual qubit is required.

Specifically, the problem with the above-mentioned conventional technique is that the DRAG pulse differs from the main control signal in both phase and shape. Therefore, in order to control frequency and phase using the single sideband (SSB) method that utilizes a local oscillator (LO) frequency and an intermediate frequency (IF), the shape of the DRAG pulse is generated using data obtained by multiplying the amplitude with the main control signal stored in memory when creating the intermediate frequency.

In other words, in the case of using the above method, since the qubit has different frequencies for the ground energy ($\omega01$) and the first excited state energy ($\omega12$), different memories must be used to store the main pulse and the DRAG signal, respectively. In addition, in order to ensure high signal quality, a high clock sampling speed and high DAC (digital-to-analog converter) bit resolution are required, thereby necessitating a very large memory capacity.

Moreover, the qubit generation method of the above-described conventional technique may not be a significant issue when the number of qubits is small. However, in order to realize a practical superconducting quantum computer, thousands or tens of thousands of qubits are needed. To control all of the qubits, thousands or tens of thousands of RF cables must be connected inside a cryogenic maintenance device or cooling device, which is practically impossible.

That is, the qubit control circuit must operate with low power in order to maintain an ultra-low temperature of 4 K inside the cryogenic maintenance device. Furthermore, as the number of qubits increases, more memory is required to generate the corresponding multiple DRAG pulses. This increases the number of memory transmission lines and the power required during memory operation, making scalability in the 4 K region difficult.

As described above, the conventional qubit control signal generation method that uses memory to store data and generate DRAG pulses is not suitable for practical use in quantum computers. Therefore, a new qubit control signal generation method is needed to effectively control quantum computers.

[Disclosure]

[Technical Problem]

The present disclosure has been derived to meet the above-described needs of the conventional technologies, and an object of the present disclosure is to provide a qubit control signal generation apparatus for superconducting quantum computer control, capable of generating a radio frequency main pulse and a DRAG (derivative removal by adiabatic gate) pulse having a differentiated shape of the main pulse with low power consumption and without using memory.

Another object of the present disclosure is to provide a qubit control signal generation method and apparatus for superconducting quantum computer control, which are capable of generating a sine-shaped pulse and a raised cosine-shaped pulse-i.e., a main pulse-without using memory, that is, without any additional portion for amplitude variation, and similarly, generating a DRAG pulse corresponding to the sine-shaped pulse or the raised cosine-shaped pulse without using memory and with low power consumption.

[Technical Solution]

A method for generating a qubit control signal for controlling a quantum computer to solve above problem, comprises: generating a first sine wave having a first phase obtained by multiplying an angular frequency, which is a sum of a first angular frequency corresponding to a center frequency and a second angular frequency corresponding to a frequency located to the left of the center frequency, by an arbitrary time of each cycle; and generating a second sine wave having a second phase obtained by multiplying an angular frequency, which is a difference between the first angular frequency and the second angular frequency, by the arbitrary time. A DRAG (derivative removal by adiabatic gate) pulse for the qubit control signal may be generated through an addition operation of the first and second sine waves.

The method may further comprise: generating a third sine wave having a third phase obtained by multiplying an angular frequency, which is a sum of the first angular frequency and the second angular frequency, by the arbitrary time; and generating a fourth sine wave having a fourth phase obtained by multiplying an angular frequency, which is a difference between the first angular frequency and the second angular frequency, by the arbitrary time. A main pulse of the qubit control signal may be generated through a subtraction operation between the third and fourth sine waves.

The method may further comprise setting a current bias of the first and second sine waves such that a scale factor is multiplied to the DRAG pulse.

The scale factor may be any real value selected from a range of 0 or more and less than 1.

The method may further comprise wave-shaping the first to fourth sine waves together so as to synthesize the main pulse and the DRAG pulse to generate a qubit control pulse.

The method may further comprise converting the qubit control pulse into a radio frequency output signal by adding a main frequency of a phase-locked loop according to a plurality of phase signals applied to a mixer.

The method may further comprise specifying an initial phase for generating each of the first to fourth sine waves.

Each of the generating of the first to fourth sine waves may comprise: repetitively accumulating a frequency codeword (FCW) within a range from zero to a preset upper limit from a predetermined initial phase; inverting even-numbered rising cycles of accumulated values obtained in the accumulating of the FCW to convert the accumulated values into a sine waveform; converting preset upper bits of sine waveform-converted accumulated values into a first analog signal; converting preset lower bits of the sine waveform-converted accumulated values into a second analog signal; and interpolating the first analog signal by adding the second analog signal to the first analog signal.

The method may further comprise synchronizing processing timing of data or signals input to four controllers, each of supplies with a phase signal and a frequency codeword (FCW) for determining an initial phase of each of the first to fourth phases, by four clock calculators coupled to the controllers, respectively.

The method may further comprise delivering, to each of the four clock calculators, some of the sub-clocks obtained by dividing a reference clock supplied from outside the qubit control signal generator into n sub-clocks, where n is 8 or 16.

The method may further comprise: determining a first main frequency according to the reference clock to generate a first phase signal and a first clock signal based on the first main frequency; determining a second main frequency, different from the first main frequency, according to the reference clock to generate a second phase signal and a second clock signal based on the second main frequency; and selecting one of the first phase signal and the second phase signal to supply the selected one to first to fourth frequency generators to respectively generate the first to fourth sine waves.

The method may further comprise distributing data and control signals input from outside to the four controllers by a main controller connected to the four controllers.

A qubit control signal generation apparatus for quantum computer control, comprise: a first frequency generator configured to generate a first sine wave having a first phase obtained by multiplying an angular frequency, which is a sum of a first angular frequency corresponding to a center frequency and a second angular frequency corresponding to a frequency located to the left of the center frequency, by an arbitrary time of each cycle; and a second frequency generator configured to generate a second sine wave having a second phase obtained by multiplying an angular frequency, which is a difference between the first angular frequency and the second angular frequency, by the arbitrary time. A DRAG (derivative removal by adiabatic gate) pulse for a qubit control signal may be generated through an addition process of the first and second sine waves.

The apparatus may further comprise: a third frequency generator configured to generate a third sine wave having a third phase obtained by multiplying an angular frequency, which is a sum of the first angular frequency and the second angular frequency, by the arbitrary time; and a fourth frequency generator configured to generate a fourth sine wave having a fourth phase obtained by multiplying an angular frequency, which is a difference between the first angular frequency and the second angular frequency, by the arbitrary time. A main pulse for the qubit control signal may be generated through a subtraction process of the fourth sine wave from the third sine wave.

To generate a qubit control pulse in which a main pulse corresponding to a first term on the right-hand side of following equation 3 and a DRAG pulse corresponding to a second term on the right-hand side are synthesized from the first to fourth sine waves, the device may perform a subtraction operation of the fourth sine wave from the third sine wave, and an addition operation of the first and second sine waves for synthesis.

The apparatus may further comprise a mixer configured to convert the qubit control pulse into a radio frequency output signal by adding the main frequency of a phase-locked loop to the qubit control pulse in accordance with a plurality of phase signals of the phase-locked loop.

The third and fourth frequency generators may respectively comprise third and fourth current biases for supplying reference-level power for operation of the third and fourth frequency generators.

The first and second frequency generators may respectively comprise first and second current biases for supplying a power level obtained by multiplying the reference level by a scale factor for the operation of the first and second frequency generators.

Each of the first to fourth frequency generators may comprise: a controller configured to output a frequency codeword (FCW), a phase signal specifying an initial phase, and an enable signal; a repetitive phase accumulator configured to repetitively accumulate the frequency codeword from an initial phase determined by the phase signal within a range from zero to a preset upper limit; a waveform converter configured to convert the repetitively accumulated values into a triangular or sine waveform by inverting even-numbered rising cycles; a nonlinear differential digital-to-analog converter (DAC) configured to convert upper bits of the sine waveform-converted values into a first analog signal; an interpolation DAC configured to convert lower bits of the sine waveform-converted values into a second analog signal; and an adder configured to interpolate the first analog signal by adding the second analog signal to the first analog signal.

Each of the first to fourth frequency generators may further comprise a clock calculator configured to align the processing timing of data or control signals input to the controller.

The apparatus may further comprise: a first phase-locked loop (PLL) configured to determine a first main frequency based on a reference clock and generate a first phase signal and a first clock signal based on the first main frequency; a second phase-locked loop configured to determine a second main frequency different from the first main frequency based on the reference clock and generate a second phase signal and a second clock signal based on the second main frequency; a clock selector configured to select one of the first and second phase signals and provide the selected phase signal to the first to fourth frequency generators; and a main controller connected to four controllers of the first to fourth frequency generators, configured to distribute data and control signals input from outside a dilution refrigerator to the four controllers.

[Advantageous Effects]

According to the present disclosure, it is possible to generate a main pulse and a DRAG (derivative removal by adiabatic gate) pulse of a qubit control signal for controlling a superconducting quantum computer with low power consumption and without using memory, thereby contributing to an increase in the number of qubits for the practical realization of quantum computers.

In addition, according to the present disclosure, the control circuit of a quantum computer may be operated efficiently with low power consumption by not using memory, and a DRAG signal generation apparatus having a scalable characteristic in an ultra-low temperature region of 4 K may be provided.

Furthermore, according to the present disclosure, a qubit control signal generation method and apparatus capable of being effectively scalable as the number of qubits increases may be provided.

[Description of Drawings]

FIG. 1 is a diagram illustrating a circuit schematic and energy levels of a transmon qubit, which is a type of superconducting qubit.

FIG. 2 is a graph exemplifying the degree of frequency spectrum spreading according to the types of main pulses usable for qubit control pulses.

FIG. 3 is a graph illustrating the degree of frequency spectrum spreading when the shape of the main pulse is fixed to a sine shape and the pulse length is varied.

FIG. 4 is a graph exemplifying how the frequency spectrum distribution changes when using a main pulse and a DRAG (derivative removal by adiabatic gate) pulse.

FIG. 5 is a graph illustrating key features of a low-power qubit control signal generation method for superconducting quantum computer control according to an exemplary embodiment of the present disclosure.

FIG. 6 is a circuit diagram of a qubit control signal generation apparatus for superconducting quantum computer control according to a first exemplary embodiment of the present disclosure.

FIG. 7 is a circuit diagram of a qubit control signal generation apparatus for superconducting quantum computer control according to a second exemplary embodiment of the present disclosure.

FIG. 8 is a circuit diagram of a qubit control signal generation apparatus for superconducting quantum computer control according to a third exemplary embodiment of the present disclosure.

FIG. 9 is a circuit diagram of a qubit control signal generation apparatus for superconducting quantum computer control according to a fourth exemplary embodiment of the present disclosure.

FIG. 10 is a block diagram for explaining a configuration unit for dividing a digital code into a 4-bit MSB and a 4-bit LSB in a frequency generator of the qubit control signal generation apparatus of FIG. 9.

FIGS. 11 to 13 are exemplary diagrams illustrating a digital code processing procedure of the frequency generator of FIG. 10.

FIG. 14 is a block diagram for explaining a configuration unit for nonlinear processing and interpolation in the frequency generator of the qubit control signal generation apparatus of FIG. 9.

FIG. 15 is a circuit diagram of a detailed structure applicable to the configuration unit for nonlinear processing and interpolation in the frequency generator of the qubit control signal generation apparatus of FIG. 9.

FIG. 16 is a graph illustrating a nonlinear sine mapping process by an interpolating DAC (digital-to-analog converter) of the frequency generator of FIG. 15.

FIG. 17 is a graph showing a 5.56 GHz 5 ns sine-shaped pulse measured at 4 K using a chip implementing the qubit control signal generation apparatus of FIG. 9.

FIG. 18 is a graph showing a 5.56 GHz 10 ns sine-shaped pulse generated using a $\pm 50$ MHz intermediate frequency based on the sine-shaped pulse of FIG. 17.

FIG. 19 is a graph showing a result of generating signals having multiple frequency components at 20 MHz frequency intervals by generating independent frequency and phase signals from each of four frequency generators of the qubit control signal generation apparatus of FIG. 9.

FIG. 20 is a graph showing a result of generating signals having multiple frequency components at 100 MHz frequency intervals by generating independent frequency and phase signals from each of four frequency generators of the qubit control signal generation apparatus of FIG. 9.

FIGS. 21 to 23 are graphs showing results of operating the qubit control signal generation apparatus of FIG. 9 in a 4 K region, setting frequency and phase according to desired DRAG pulses from four frequency generators, and measuring how the frequency spectrum distribution changes while varying a scale factor qscale.

FIG. 24 is a microscopic image of a chip implementing the qubit control signal generation apparatus according to the present exemplary embodiment.

FIG. 25 is a magnified microscopic image of the frequency generator portion of the qubit control signal generation apparatus of FIG. 24.

[Best mode of the Invention]

For a clearer understanding of the features and advantages of the present disclosure, exemplary embodiments of the present disclosure will be described in detail with reference to the accompanying drawings. However, it should be understood that the present disclosure is not limited to particular embodiments disclosed herein but includes all modifications, equivalents, and alternatives falling within the spirit and scope of the present disclosure.

The terminologies including ordinals such as "first" and "second" designated for explaining various components in this specification are used to discriminate a component from the other ones but are not intended to be limiting to a specific component. For example, a second component may be referred to as a first component and, similarly, a first component may also be referred to as a second component without departing from the scope of the present disclosure. As used herein, the term "and/or" may include a presence of one or more of the associated listed items and any and all combinations of the listed items.

In the description of exemplary embodiments of the present disclosure, "at least one of A and B" may mean "at least one of A or B" or "at least one of combinations of one or more of A and B". In addition, in the description of exemplary embodiments of the present disclosure, "one or more of A and B" may mean "one or more of A or B" or "one or more of combinations of one or more of A and B".

When a component is referred to as being "connected" or "coupled" to another component, the component may be directly connected or coupled logically or physically to the other component or indirectly through an object therebetween. Contrarily, when a component is referred to as being "directly connected" or "directly coupled" to another component, it is to be understood that there is no intervening object between the components. Other words used to describe the relationship between elements should be interpreted in a similar fashion.

The terminologies are used herein for the purpose of describing particular exemplary embodiments only and are not intended to limit the present disclosure. The singular forms include plural referents as well unless the context clearly dictates otherwise. Also, the expressions "comprises," "includes," "constructed," "configured" are used to refer a presence of a combination of stated features, numbers, processing steps, operations, elements, or components, but are not intended to preclude a presence or addition of another feature, number, processing step, operation, element, or component.

Unless defined otherwise, all terms used herein, including technical or scientific terms, have the same meaning as commonly understood by those of ordinary skill in the art to which the present disclosure pertains. Terms such as those defined in a commonly used dictionary should be interpreted as having meanings consistent with their meanings in the context of related literatures and will not be interpreted as having ideal or excessively formal meanings unless explicitly defined in the present application.

Hereinafter, preferred exemplary embodiments of the present disclosure will be described in more detail with reference to the accompanying drawings. In describing the present disclosure, the same reference numerals are used for the same components in the drawings to facilitate overall understanding, and redundant descriptions of the same components are omitted.

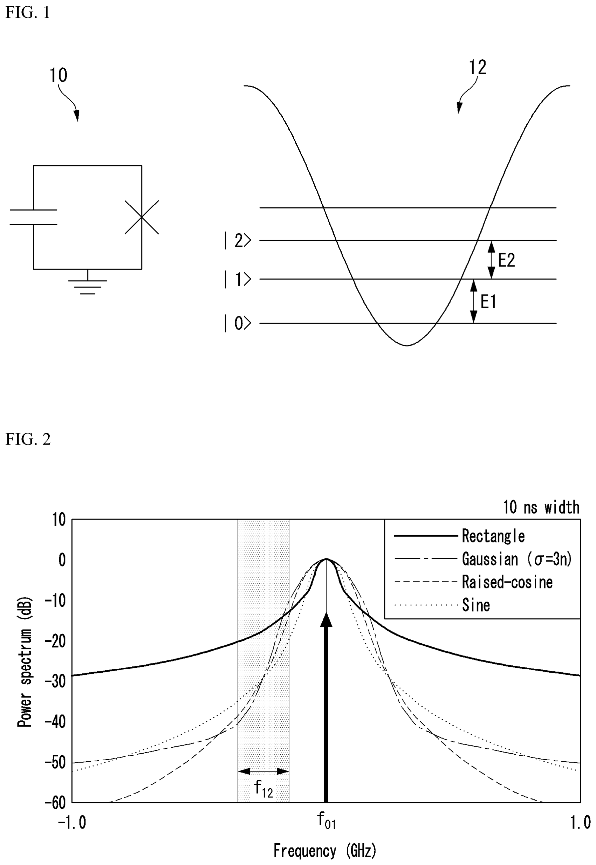

FIG. 1 is a diagram illustrating a circuit schematic and energy levels of a transmon qubit, which is a type of superconducting qubit.

As shown in FIG. 1, a transmon qubit may be represented in an isolated form as a superconducting island region composed of a capacitance between two nodes or two conductors and a Josephson junction inductance (denoted by X), as shown in the circuit schematic 10. The number of Cooper pairs present in the superconducting island region, i.e., the amount of charge, may correspond to one of the specific energy levels $|0\rangle$, $|1\rangle$ and $|2\rangle$ on the curve 12 representing the potential energy of the qubit. The Josephson junction functions as a valve that supplies Cooper pairs to the superconducting island region.

The energy levels of the transmon qubit, due to the nonlinear characteristics of the Josephson junction, deviate from a parabolic shape as the energy level increases. That is, the curve spreads outward on both sides from the center as the energy increases, and accordingly, the higher the energy level, the narrower the interval between adjacent energy levels becomes. According to this characteristic, the energy E1 between the ground state and the first excited state, and the energy E2 between the first excited state and the second excited state may be clearly distinguished. Thus, the energy level $|0\rangle$ of the ground state and the energy level $|1\rangle$ of the first excited state may be used as a qubit in a quantum computer.

When the transmon qubit is in a simple harmonic potential, the energy level $\omega 12$ of the first excited state may be expressed as the ground state energy level $\omega 01$ plus a predetermined energy $\alpha$. Here, the predetermined energy may correspond to an anharmonicity value that is added to the qubit frequency $\omega 0$ or f01 when representing the energy level $\omega 12$ of the first excited state.

The qubit frequency f01, which is a radio frequency (RF), may be used for rotation control of the qubit. The rotation angle θ of the qubit may be controlled by the RF pulse energy of the qubit frequency, and the rotation state of the rotation axis φ may be controlled by the RF phase of the qubit frequency.

The qubit frequency f01 may be between 5 and 7 GHz, and the difference from the second frequency f12 located to the left of the qubit frequency may be 150 to 350 MHz. The second frequency f12 is a frequency at which the power of the qubit control pulse is intended to be reduced. The coherence time related to the qubit control signal between the qubit frequency and the second frequency is typically less than 100 μs. In the following description, the qubit frequency is also referred to as the center frequency.

The above-described qubit has characteristics that vary depending on the type of qubit, and both the energy of the ground state ω01 (hereinafter also referred to as the "ground energy") and the energy of the first excited state ω12 (hereinafter also referred to as the "first state energy") differ. Therefore, the RF signal for controlling the qubit may vary in amplitude, length, shape, phase, and frequency.

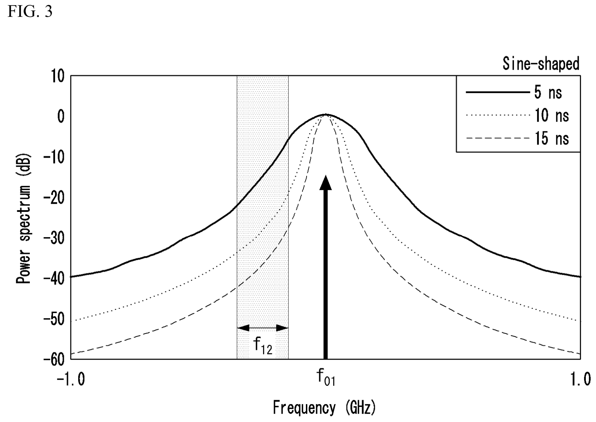

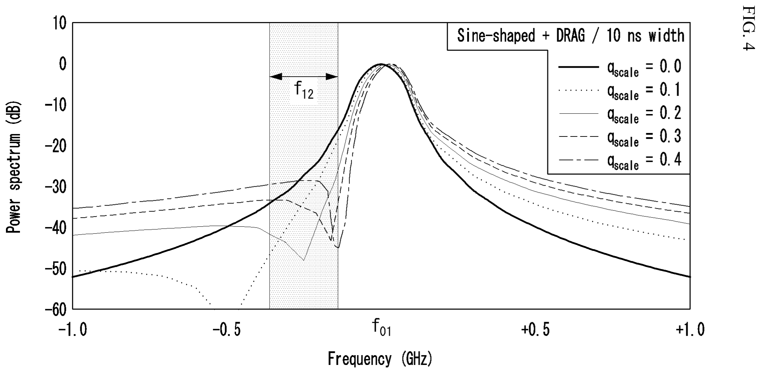

FIG. 2 is a graph exemplifying the degree of frequency spectrum (power spectrum) spreading according to the types of main pulses usable for qubit control pulses. FIG. 3 is a graph exemplifying the degree of frequency spectrum spreading when the main pulse shape is fixed to a sine shape and the pulse length is varied. FIG. 4 is a graph exemplifying how the distribution of the frequency spectrum changes when using both a main pulse and a DRAG (derivative removal by adiabatic gate) pulse.

As shown in FIG. 2, the length or pulse width of a main pulse for qubit control may be approximately 30 ns in the case of a rectangle-shaped pulse. The rectangle-shaped pulse has a relatively wide spreading on both sides of the center frequency, and such a shape is a major factor in degrading the single-gate fidelity in quantum computing.

In other words, in the qubit control signal for a quantum computer, the second frequency f12 is typically 150 to 350 MHz lower than the center frequency f01. Although this may vary depending on the qubit design, during qubit control, spectral leakage exceeding a certain threshold at the second frequency f12, which is always located to the left of the center frequency f01, may cause degradation in single-gate fidelity.

On the other hand, Gaussian-shaped, raised-cosine-shaped, and sine-shaped pulses that may be generated through pulse shaping from a rectangle-shaped pulse exhibit relatively smaller spreading than the rectangle-shaped pulse. That is, it may be confirmed that the power spectral leakage at the second frequency f12 for each of these pulses is reduced compared to that of the rectangle-shaped pulse.

Furthermore, as shown in FIG. 3, when the pulse shape is fixed to a sine shape and the pulse length is varied-specifically, when a pulse with a shorter pulse width suitable for qubit control is generated-it may be seen that the shorter the pulse length, the more severe the spreading of the power spectrum on both sides of the center frequency becomes. This indicates that a shorter pulse length requires more power at the second frequency f12, which increases noise at the second frequency and may cause additional errors in qubit operation.

Currently, in quantum computer research, DRAG (derivative removal by adiabatic gate) pulses as shown in FIG. 4 are used in consideration of the above conditions. FIG. 4 shows the power spectrum distribution when a DRAG pulse is added to a 10 ns sine-shaped main pulse. That is, by adding a DRAG pulse to the sine-shaped pulse and varying the scale factor qscale of the DRAG pulse from 0.0 to 0.4, the distribution of the frequency spectrum may be observed. As shown, the use of a DRAG pulse may reduce power at the second frequency.

That is, by using a DRAG pulse, a pulse shape may be created in which the left portion of the center frequency f01 has lower energy or power, and the right portion has higher power. Since the second frequency f12 is located to the left of the center frequency f01, the use of a DRAG pulse may reduce the power at the second frequency. Additionally, the second frequency with the greatest power reduction may be adjusted according to the scale factor. This allows the effect to be maximized by using an appropriate scale factor based on the difference between the center frequency f01 and the second frequency f12, which varies depending on qubit design. By adding the above-described DRAG pulse, spectral asymmetry may be induced, and leakage at the second frequency f12 may be reduced.

The above-described main pulse, as a radio frequency signal for qubit control, may have a sine shape or a cosine shape. The DRAG pulse has a shape that is the derivative of the main pulse and may have a 90° phase difference from the phase of the main pulse. The DRAG pulse has a shape in which the main pulse is multiplied by a scale factor qscale. The scale factor is a value related to the qubit characteristics and may be represented as the energy difference between the first excited state energy (first state energy) ω12 and the ground state energy (ground energy) ω01, or a value corresponding thereto.

In addition, the frequency of the main pulse of the qubit control signal is typically designed to be between 5 and 7 GHz, and each qubit control signal may have a unique frequency differing by several tens to several hundreds of megahertz (MHz). Along with frequency, the phase of the RF signal is also an important factor in qubit control.

Therefore, in order to effectively generate a qubit control signal, a single sideband (SSB) method is generally used. The SSB method combines a relatively low intermediate frequency (IF) signal of several hundred MHz with a local oscillator (LO) signal of several GHz to generate LO+IF or LO-IF frequency signals. Using this method, multiple qubit control RF signals may be generated by adding or subtracting the relatively low IF to or from the relatively high LO frequency, and the phase may also be freely adjusted.

However, in the above-described comparative example of the qubit control signal generation method, a linear digital-to-analog converter (linear DAC) must be used to generate the IF signal. That is, sine wave data must be provided to the linear DAC to generate the IF signal. In particular, to generate a high-resolution IF signal of several hundred MHz, relatively more data is required, which leads to the need for larger memory. Furthermore, the greater the memory, the more power is consumed.

Additionally, in order to generate a DRAG pulse, the pulse shape must be generated flexibly. For example, a Gaussian shape and its derivative shape are stored by being multiplied by the IF signal provided to the DAC. Since each qubit has a different frequency, the memory required for this cannot be shared. Therefore, in order to generate a DRAG pulse, memory is required to separately generate and store both the main pulse and the DRAG pulse, and because this memory cannot be shared with other qubits, more memory is required as the number of qubits increases.

Accordingly, in the present exemplary embodiment, a method of generating a main pulse and a DRAG pulse without using memory is proposed in order to solve the problem of a significant increase in memory capacity required as the number of qubits increases to several tens, hundreds, thousands, or tens of thousands.

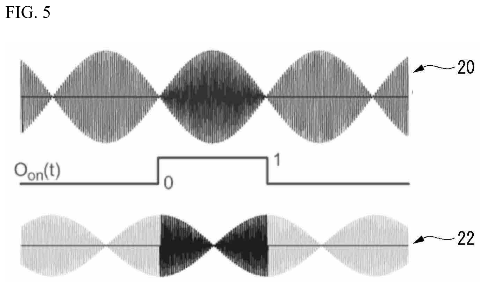

FIG. 5 is a graph illustrating key features of a low-power qubit control signal generation method for superconducting quantum computer control according to an exemplary embodiment of the present disclosure.

As shown in FIG. 5, the qubit control signal generation method is configured to generate a main pulse and a DRAG pulse using sine-shaped pulses and raised cosine-shaped pulses without using rectangle-shaped pulses.

In the unit pulse shape of the qubit control signal, the sine shape and the raised cosine shape exhibit characteristics similar to those of a Gaussian shape, with slight differences in frequency spreading. Accordingly, in the present exemplary embodiment, desired RF pulses are generated by applying trigonometric synthesis to the sine shape and the raised cosine shape. For example, by adding or subtracting an intermediate frequency (IF) to or from a main frequency corresponding to a local oscillator (LO) frequency, a signal resulting from the multiplication of the main frequency and the intermediate frequency (hereinafter referred to as a "third signal") may be obtained. If this third signal is appropriately processed, an RF pulse having a sine shape may be arbitrarily generated.

More specifically, since the intermediate frequency (IF) signal determines the frequency of the sine-shaped main pulse, the pulse width of the main pulse may be controlled by varying the frequency of the IF signal, and the phase of the main frequency signal may be controlled by changing the phases of the two generated signals. Furthermore, a raised cosine signal may be generated by adding a rectangular pulse of the main frequency to a sine signal. Using this method, a main pulse may be generated using two sine-shaped frequency signals without any additional circuit or memory.

Moreover, the sine shape and the raised cosine shape respectively have cosine and sine shapes as their derivatives. This implies that the DRAG pulse may be generated using the same method as the generation of the main pulse. That is, since the DRAG pulse has a 90° phase difference from the main pulse, a DRAG pulse corresponding to the main pulse may be generated by appropriately controlling the phases of the two frequency signals. Additionally, by multiplying a scale factor, the amplitude or shape of each generated frequency signal may be adjusted.

As described above, in the present exemplary embodiment, the main pulse and the DRAG pulse for qubit control may be generated without memory by using only sine-shaped pulses and/or cosine-shaped pulses.

The above-described main pulse 20 may be expressed by the following Equation 1.

【Equation 1】

$$O_{main}(t) = O_{on}(t) \sin(\omega_w t) \cos(\omega_{01} t)$$

$$= O_{on}(t) \cdot \frac{1}{2}\{\sin[(\omega_{01} + \omega_w)t] - \sin[(\omega_{01} - \omega_w)t]\}$$

In Equation 1, $O_{main}(t)$ represents the sine-shaped main pulse at time t, and $O_{on}(t)$ represents the on-time pulse of the frequency generation circuit.

As shown in Equation 1, the sine-shaped main pulse may be expressed in the form of a product of a sine function and a raised cosine function. By expanding this using a sine function identity, the sine-shaped main pulse 20 may be synthesized by subtracting two sine curves. In trigonometric operations, a subtraction corresponds to adding a sine curve flipped by 180 degrees.

Similar to the generation process of the above main pulse, the DRAG pulse 22 may be expressed by the following Equation 2.

【Equation 2】

$$O_{DRAG}(t) = O_{on}(t)q_{scale}\cos(\omega_w t)\sin(\omega_{01}t)$$

$$= O_{on}(t)q_{scale}\frac{1}{2}\{\sin[(\omega_{01}+\omega_w)t]+\sin[(\omega_{01}-\omega_w)t]\}$$

In Equation 2, $O_{DRAG}(t)$ represents the DRAG pulse at time t, $q_{scale}$ represents the scale factor, and $O_{on}(t)$ represents the on-time pulse of the frequency generation circuit.

As shown in Equation 2, the DRAG pulse, which has a 90-degree phase difference from the main pulse, may be expressed in the form of a product of the scale factor, a cosine function, and a sine function. Here, the cosine function corresponds to the derivative of the sine function of the main pulse, and the sine function corresponds to the derivative of the cosine function of the main pulse. When expanded using a sine function identity, the product of the cosine function and the sine function in the DRAG pulse may be expressed as a synthesized form of two added sine curves. That is, the raised cosine-shaped DRAG pulse may be generated as a synthesized form of two added sine curves.

The process of synthesizing a qubit control pulse $O(t)$ using the above-described main pulse and DRAG pulse, may be expressed as the following Equation 3. The qubit control pulse may also be referred to as a qubit-driving pulse.

【Equation 3】

$$O(t) = O_{on}(t)\frac{1}{2}\{\sin[(\omega_{01}+\omega_w)t]-\sin[(\omega_{01}-\omega_w)t]\}$$

$$+q_{scale}\{\sin[(\omega_{01}+\omega_w)t]+\sin[(\omega_{01}-\omega_w)t]\}$$

In Equation 3, $O(t)$ represents the qubit control pulse, $O_{on}(t)$ represents the on-time pulse of the frequency generation circuit, $q_{scale}$ represents the scale factor, $\omega_{01}$ represents the phase angle at time t for the qubit ground state, and $\omega_w$ represents the phase angle at time t for the qubit.

As may be seen from Equation 3, the qubit control pulse may be simply synthesized by adding four sine curves. Among these four sine curves, two are used to generate the main pulse, and the remaining two are used to generate the DRAG pulse. In this manner, according to the present exemplary embodiment, the main pulse and the DRAG pulse for qubit control may be generated without memory.

The qubit control pulse generated using the above four sine curves may be used in cryogenic quantum computer control. That is, it may effectively generate a qubit control pulse for a quantum computer operating in an ultra-low temperature environment inside a dilution refrigerator or in the 4 K stage.

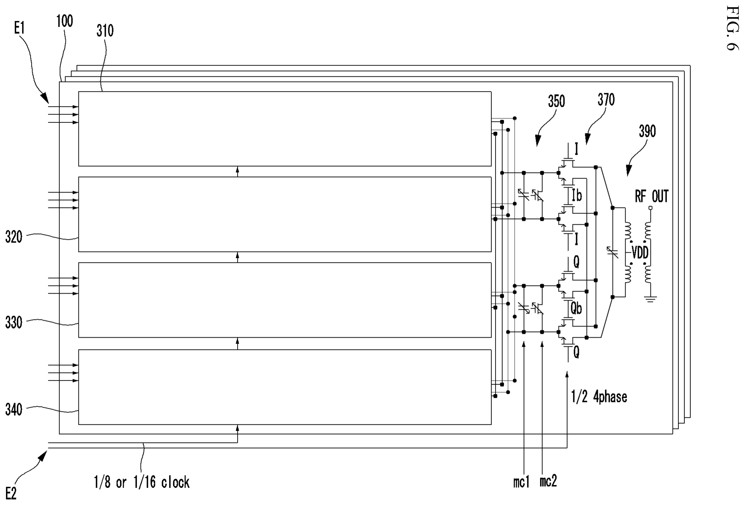

FIG. 6 is a circuit diagram of a qubit control signal generation apparatus for superconducting quantum computer control according to a first exemplary embodiment of the present disclosure.

As shown in FIG. 6, the qubit control signal generation apparatus includes at least one driver 100 for generating a qubit control signal. Each driver 100 may include first to fourth frequency generators 310, 320, 330, and 340, a waveform shaping circuit 350, a mixer 370, and an output terminal (390). The frequency generators may be referred to as frequency generation blocks.

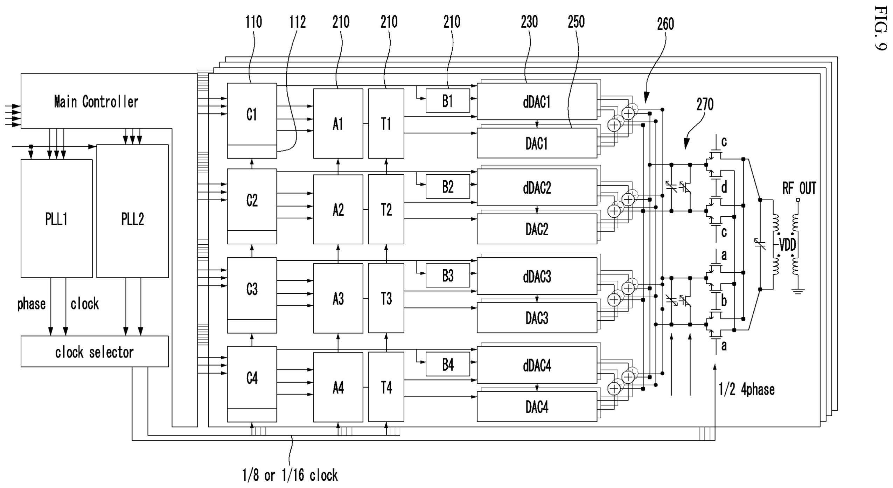

Each frequency generator may include a controller, a clock calculator, a rotational phase accumulator, a triangular transform unit, a current bias, a non-linear differential digital-to-analog converter (DAC), an interpolating DAC, and a synthesis unit. Details regarding the internal configuration of the above-described frequency generator will be described in detail with reference to FIG. 9.

Among the first to fourth frequency generators 310, 320, 330, and 340, two are used to generate two sine functions for the main pulse, and the remaining two are used to generate two sine functions for the DRAG pulse.

That is, as shown in Equation 3 above, by appropriately synthesizing four sine functions-specifically, by subtracting two of the sine functions according to trigonometric subtraction to form the main pulse portion, and by adding the remaining two sine functions with a predetermined scale factor applied to form the DRAG pulse portion-it is possible, according to this exemplary embodiment, to simply generate a qubit control pulse by synthesizing four sine curves.

The qubit control pulses generated from the four frequency generators 310, 320, 330, and 340 are combined into a raised cosine shape by the waveform shaping circuit 350, and are combined with the intermediate frequency by the mixer 370, and may be read out as a single RF signal.

Here, the mixer 370 may be configured to output an RF signal with a frequency obtained by combining a relatively slow first frequency pulse with a relatively fast second frequency pulse through multiple switch pairs that operate on/off in response to control signals having a Q-component Q and inverted Q-component Qb of the main frequency as the LO (local oscillator) frequency, and an I-component I and inverted I-component Ib of the main frequency.

The output circuit 390 may have the structure of an isolated converter and may be configured to output an RF signal based on the internal power supply voltage (VDD). The RF signal (RF out) output through the output circuit 390 may have a form in which multiple qubit control pulses or tones are arranged, depending on the readout frequency used for qubit readout, a predetermined digital clock, and the pulse spacing of the DAC. The readout frequency may be 8 GHz, the digital clock may be 2 GHz, and the pulse spacing of the DAC may be several tens of MHz. The readout frequency may differ from the frequency used for qubit control or qubit write.

In this exemplary embodiment, the frequency generators 310, 320, 330, and 340, the waveform shaping circuit 350, and the mixer 370 of the qubit control signal generation apparatus may receive a data signal, a first control signal, and a second control signal through a plurality of cables connected to the outside of the cryogenic device. A part E1 of the data signal and the first control signal may include a frequency codeword FCW, a clock CLK, and an enable signal EN. The remaining part E2 of the data signal and the first control signal may include a reference signal, a clock signal, a phase signal, etc. The reference signal or clock signal may be referred to as a reference clock. In addition, the second control signal delivered to the waveform shaping circuit 350 may include two main control signals mc1 and mc2.

Here, the frequency codeword FCW consists of digital bits, some of which are used to control a digital preprocessing unit for generating the main pulse in the frequency generator, and the remaining bits are used to control an analog processing unit for generating the DRAG pulse in the frequency generator. The clock may have the same frequency as the data signal to perform synchronous processing of the data signal composed of digital bits. The enable signal may be used to determine the on/off or active/inactive state of each component, such as the controller and the rotational phase accumulator. The reference clock is used to operate a phase-locked loop and may be a faster and cleaner clock than the clock having the same frequency as the data signal. The phase signal may be used to designate the initial phase position of the rotational phase accumulator and to control the operation of the switch pairs in the mixer 370. The main control signals mc1 and mc2 may be used to control the operation of the waveform shaping circuit 350.

The clock signal of the above-described reference clock may include a 1/8 clock or a 1/16 clock, which respectively divide the main clock by eight or sixteen, and such clock signals may be applied to each of the frequency generators 310, 320, 330, and 340. In addition, the above-described phase signal may include four signals that divide the main phase, determined by the reference clock, by two. These phase signals-namely, an in-phase signal, a quadrature-phase signal, an inverted in-phase signal, and an inverted quadrature-phase signal-may be applied to the control terminals of the four switch pairs of the mixer 370.

Meanwhile, in order to individually deliver data signals and control signals from outside a cryogenic maintenance unit or cryostat to a qubit control signal generation apparatus installed within the cryogenic maintenance unit or cryostat, a number of cables equal to sixteen times the number of drivers must be used to transmit each signal. Therefore, to reduce the use of such a large number of cables, a main controller may be installed in the qubit control signal generation apparatus.

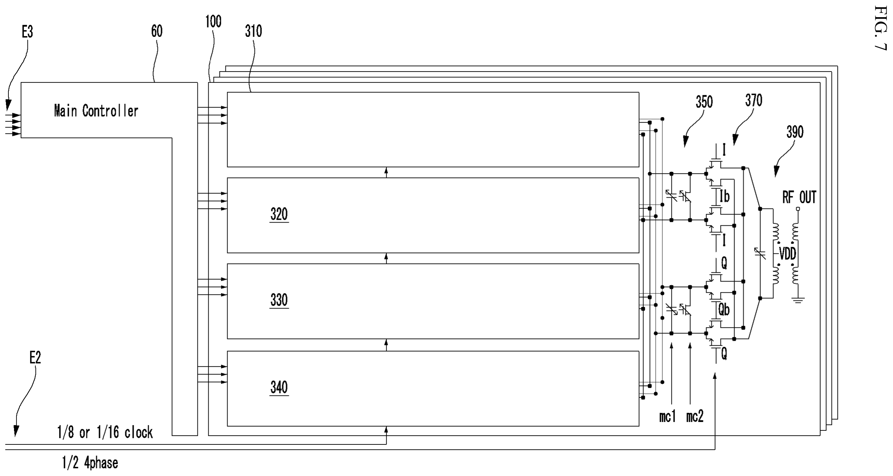

FIG. 7 is a circuit diagram of a qubit control signal generation apparatus for superconducting quantum computer control according to a second exemplary embodiment of the present disclosure.

As shown in FIG. 7, the qubit control signal generation apparatus may include a main controller 60 and at least one driver 100. The driver 100, as described earlier with reference to FIG. 6, may include four frequency generators 310, 320, 330, and 340, a waveform shaping circuit 350, a mixer 370, and an output circuit 390.

By using the main controller 60, data signals and control signals received from the outside may be copied and individually provided to the four frequency generators 310, 320, 330, and 340 included in at least one driver 100, thereby omitting the need for direct cable connections between the external computing device and each frequency generation block.

By using the main controller 60, the operation of the waveform shaping circuit 350-which includes variable capacitors and variable switches connected in parallel between the four frequency generators 310, 320, 330, and 340 and the mixer 370-can be controlled through internally generated main control signals mc1 and mc2. In addition, by using the waveform shaping circuit 350, signals combined from two pairs among the four frequency generators 310, 320, 330, and 340 and delivered to the mixer 370 may be selectively shaped into a raised cosine form before transmission.

Meanwhile, the four frequency generators 310, 320, 330, and 340 of each driver 100 may be supplied with clock signals divided into 1/8 or 1/16 of the main clock, and the mixer 370 may be supplied with multiple phase signals-i.e., four half-phase (1/2 phase) signals. As the number of qubits increases, the number of such clock and phase signals also increases. Therefore, when the number of qubits exceeds a certain threshold, power may be concentrated at the second frequency f12 located to the left of the center frequency of the qubit control signal, resulting in significant noise at the second frequency. To prevent qubit control errors caused by such noise, in the present exemplary embodiment, a plurality of phase-locked loops (PLLs) may be mounted within the qubit control signal generation apparatus.

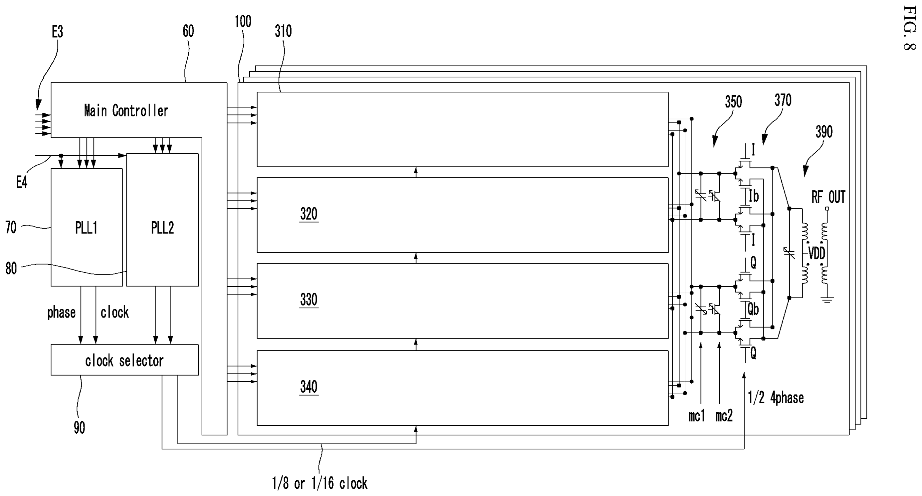

FIG. 8 is a circuit diagram of a qubit control signal generation apparatus for superconducting quantum computer control according to a third exemplary embodiment of the present disclosure.

As shown in FIG. 8, the qubit control signal generation apparatus may include a main controller 60, a first phase-locked loop (PLL1) 70, a second phase-locked loop (PLL2) 80, a clock selector 90, and at least one driver 100. Each driver 100, as previously described with reference to FIG. 6, may include four frequency generators 310, 320, 330, and 340, a waveform shaping circuit 350, a mixer 370, and an output circuit 390.

The first phase-locked loop (PLL1) 70 may generate a first output signal based on a reference signal. The first phase-locked loop 70 controls the first output signal by using the phase difference between the reference signal and a feedback signal from the first output. The first phase-locked loop 70 may adjust the frequency of the first output signal to match the reference signal. The frequency of the first output signal may include a first LO frequency for qubit control. The first LO frequency may be any frequency selected from 10 GHz to 13 GHz, and may be referred to as the first main frequency.

The second phase-locked loop (PLL2) 80 may generate a second output signal based on the reference signal. The second phase-locked loop 80 controls the second output signal by using the phase difference between the reference signal and a feedback signal from the second output. The second phase-locked loop 80 may adjust the frequency of the second output signal to match the reference signal. The frequency of the second output signal may include a second LO frequency for qubit readout. The second LO frequency may be any frequency selected from 14 GHz to 16 GHz, and may be referred to as the second main frequency.

The first phase-locked loop 70, as the first output signal, may be configured not to directly output a clock of the first main frequency, but instead to output a 1/n clock of the 1/n main frequency obtained by dividing the first main frequency by n. In this exemplary embodiment, it may output a 1/8 clock of the first main frequency. Similarly, the second phase-locked loop 80, as the second output signal, may be configured not to directly output a clock of the second main frequency, but to output a 1/n clock of the 1/n frequency obtained by dividing the second main frequency by n. In this exemplary embodiment, it may output a 1/8 clock of the second main frequency.

Additionally, the first phase-locked loop 70, as another first output signal, may be configured not to directly output a signal with the initial phase or main phase of the first main frequency, but to output a 1/n phase signal obtained by dividing the main phase into n parts. In this exemplary embodiment, the first phase-locked loop 70 may output four 1/2-phase signals as the phase signal. Similarly, the second phase-locked loop 80, as another second output signal, may be configured not to directly output a signal with the initial phase or main phase of the second main frequency, but to output a 1/n phase signal obtained by dividing the main phase into n parts. In this exemplary embodiment, the second phase-locked loop 80 may output four 1/2-phase signals as the phase signal.

As described above, in the present exemplary embodiment, a plurality of phase-locked loops may be used to prevent excessive power consumption and resulting large noise at a specific second frequency when generating clocks required for at least one driver 100. The plurality of phase-locked loops may be configured to divide the entire frequency band supported by each driver into multiple segments, with each phase-locked loop handling one segment.

The clock selector 90 may receive phase signals and clock signals from the plurality of phase-locked loops, and may be configured to select one of the received phase signals and one of the clock signals to provide to each driver. For example, the clock selector may receive a first phase signal and a first clock signal from the first phase-locked loop 70, and a second phase signal and a second clock signal from the second phase-locked loop 80, and may be configured to select one from the first and second phase signals and one from the first and second clock signals for output. The clock selector 90 may include a first switch for selecting between the first and second clock signals, and a second switch for selecting between the first and second phase signals.

By using the first phase-locked loop 70, the second phase-locked loop 80, and the clock selector 90, the selected clock signal from the clock selector 90 may be effectively used to provide operation timing or synchronization timing to the four frequency generators 310, 320, 330, and 340 of each driver 100, and the selected phase signal from the clock selector 90 may be used to control the operation of the mixer 370 to modulate multiple qubit control pulses onto a predetermined readout frequency and deliver them to the output circuit 390.

Meanwhile, although this exemplary embodiment illustrates the use of two phase-locked loops, the present disclosure is not limited to such a configuration. Depending on the number of qubits, three or more, or even several dozen phase-locked loops may be employed.

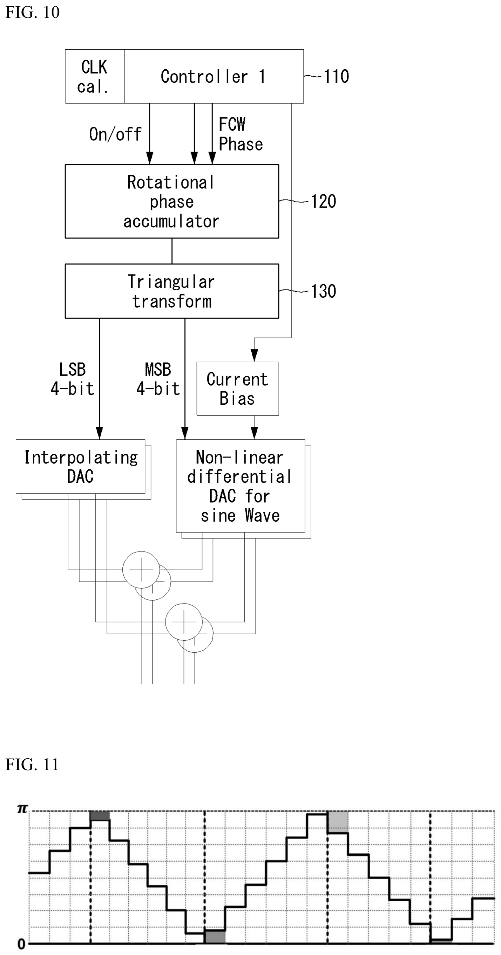

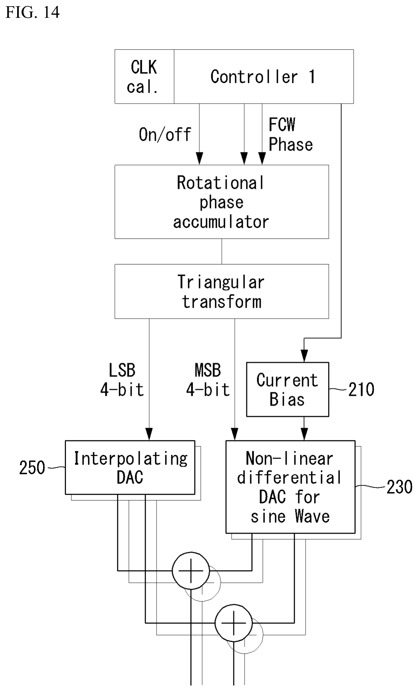

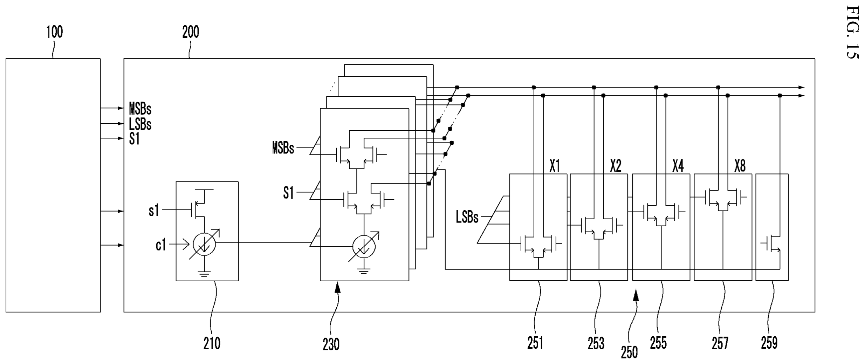

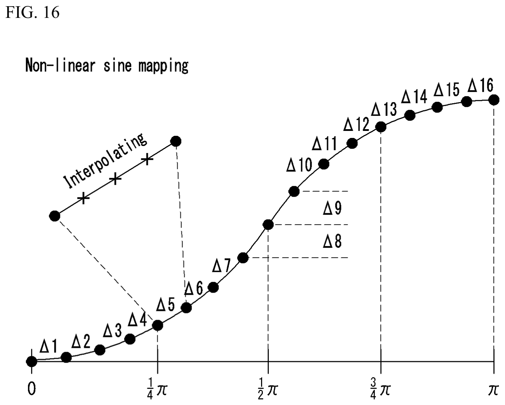

FIG. 9 is a circuit diagram of a qubit control signal generation apparatus for superconducting quantum computer control according to another exemplary embodiment of the present disclosure. FIG. 10 is a block diagram illustrating a configuration of dividing a digital code into a 4-bit MSB and a 4-bit LSB in the frequency generator of the qubit control signal generation apparatus of FIG. 9. FIGS. 11 to 13 are example diagrams illustrating a digital code processing procedure of the frequency generator in FIG. 10. FIG. 14 is a block diagram illustrating a configuration for nonlinear processing and interpolation in the frequency generator of the qubit control signal generation apparatus of FIG. 9. FIG. 15 is a circuit diagram illustrating a detailed structure applicable to the configuration for nonlinear processing and interpolation in the frequency generator of the qubit control signal generation apparatus of FIG. 9. FIG. 16 is a graph illustrating a nonlinear sine mapping process by an interpolating DAC (digital-to-analog converter) of the frequency generator in FIG. 15.

As shown in FIG. 9, the qubit control signal generation apparatus may include a main controller 60, a first phase-locked loop (PLL1) 70, a second phase-locked loop (PLL2) 80, a clock selector 90, and at least one driver 100.

The qubit control signal generation apparatus may be installed inside a dilution refrigerator. The qubit control signal generation apparatus may be configured to receive, through four channels E1 and one channel E4, only data signals and control signals such as clock signals and enable signals delivered to the main controller 60, and reference signals delivered to the phase-locked loops 70 and 80, from a computing device, external control device, external measurement device, or a combination thereof located outside the dilution refrigerator.

The main controller 60 may store, as information for generating qubit control pulses, a frequency codeword FCW, phase, pulse width, pulse shape, single sideband SSB selection information, and the like. All or some of this information may be preset by an external computing device or external management and control equipment, or may be input during operation. Of course, at least some of the information may be preset during the manufacture of the qubit control signal generation apparatus.

The main controller 60 may deliver data signals and control signals such as reference signals and synchronization signals to the first phase-locked loop 70, the second phase-locked loop 80, and at least one driver 100. For example, the main controller 60 may copy and deliver at least a portion of the data signals and control signals received from the outside to the first to fourth controllers C1 to C4, the first phase-locked loop 70, and the second phase-locked loop 80.

Detailed descriptions of the main controller 60, the first phase-locked loop 70, the second phase-locked loop 80, and the clock selector 90 are omitted herein and may be referred to in the previous descriptions associated with FIGS. 7 and 8.

The driver 100 may include a digital part and an analog part. The digital part may be referred to as a digital preprocessing unit, and the analog part may be referred to as an analog processing unit.

The digital part may include first to fourth controllers C1 to C4, first to fourth clock calculators, first to fourth rotational phase accumulators A1 to A4, and first to fourth triangular transform units T1 to T4. The analog part may include first to fourth current biases B1 to B4, first to fourth non-linear differential DACs dDAC1 to dDAC4, first to fourth interpolating DACs DAC1 to DAC4, an adder circuit 260, a waveform shaping circuit 350, a mixer 370, and an output circuit 390.

In the digital part, each of the first to fourth controllers C1 to C4 may be referred to simply as a controller 110. The first to fourth clock calculators connected to each controller 110 may be referred to simply as clock calculators (CLK cal.) 112. Each of the first to fourth rotational phase accumulators A1 to A4 may be referred to simply as a rotational phase accumulator 120. Each of the first to fourth triangular transform units T1 to T4 may be referred to simply as a triangular transform unit 130.

In the analog part, each of the first to fourth current biases B1 to B4 may be referred to simply as a current bias 210. Each of the first to fourth non-linear differential DACs dDAC1 to dDAC4 may be referred to simply as a non-linear differential digital-to-analog converter 230. Each of the first to fourth interpolating DACs DAC1 to DAC4 may be referred to simply as an interpolating DAC 250.

As described in Equation 3 above, the qubit control signal generation apparatus includes independent frequency generation units that generate four intermediate frequency (IF) signals. The main pulse and DRAG pulse generated by the plurality of IF signals may be combined with signals from the phase-locked loops via the mixer 370.

In the present exemplary embodiment, the independent frequency generators may include the first to fourth frequency generators (refer to 310, 320, 330, and 340 in FIGS. 6 to 8). The four intermediate frequency signals generated from the four frequency generators may be combined with signals from the phase-locked loops through the mixer 370. The signal from the phase-locked loop may be a signal having an LO (local oscillator) frequency and fundamental phase, a 1/n frequency obtained by dividing the LO frequency into multiple parts, or a 1/n phase signal obtained by dividing the fundamental phase into multiple parts. The LO frequency may be referred to as the fundamental frequency.

To describe the frequency generation units in more detail, each frequency generation unit may include, as shown in FIGS. 9, 10, and 14, a controller 110, a clock calculator 112, a rotational phase accumulator 120, a waveform transform unit (T1) 130, a current bias 210, a non-linear differential DAC 230, and an interpolating DAC 250.

The controller 110 receives data signals and control signals from the main controller 60 and, based on these signals, may transmit a frequency codeword (FCW), a phase signal, and an enable signal to the rotational phase accumulator 120. The controller 110 may store information for operating the corresponding frequency generator, such as the frequency codeword (FCW), phase, pulse width, pulse shape, and single sideband (SSB) selection information, for the operation of the non-linear waveform differential DAC.

Here, the FCW may be a frequency-related signal that is set or input from a user device, external computing device, external management or measurement device, etc., to determine the frequency generated by each frequency generator of the driver 100. The FCW may include values input by the user.

The phase signal is a signal used to determine the phase of the frequency generated by the frequency generator. The phase signal may be configured to designate the initial position of the FCW phase stored in memory when the FCW is generated by adding or accumulating the FCW value in the memory.

The enable signal is used to select the on/off, enable/disable, or active/inactive operating mode of components or units within the driver 100. The enable signal may include a first signal level corresponding to on, enable, or active, and a second signal level corresponding to off, disable, or inactive. The first signal level may correspond to logic 1, and the second signal level may correspond to logic 0, or vice versa. This enable signal may be applied to the rotational phase accumulator 120, current bias 210, and non-linear differential DAC 230.

Referring again to FIGS. 9 and 10, the clock calculator (CLK cal.) 112 may function to synchronize the timing of data processing or signal processing at the controller 110 with the operations of other controllers. The clock calculator 112 may synchronize all incoming clocks to the controllers to prevent clock delay caused by the physical layout relationship among the main controller 60 and the first to fourth controllers (C1 to C4), as well as the wiring lengths connecting them.

As shown in FIG. 11, the rotational phase accumulator 120 receives an initial phase value ($\varphi_0$) from the controller 110, then repeatedly accumulates it by reading the frequency codeword (FCW) from a storage unit and adding it to the initial phase value ($\varphi_0$).

The FCW is a factor that determines the frequency of the non-linear waveform. The accumulation of the FCW continues until the accumulated value reaches a predetermined upper limit. When the accumulated value reaches the upper limit, the rotational phase accumulator 120 subtracts the upper limit from the accumulated value and continues accumulating the FCW from the remaining value. In this way, the accumulation value increases from zero or near-zero to the upper limit and is repeatedly reset. This repeated accumulation value may be referred to as the "repetitive accumulation value." The magnitude of the repetitive accumulation value is related to the phase of the pulse generated by the frequency generator, and the upper limit of the repetitive accumulation value may correspond to half of the total phase variation range of the generated pulse.

In the present exemplary embodiment, the upper limit of the repetitive accumulation value is $\pi$, and the repetitive accumulation value may be set to repeatedly increase from 0 to $\pi$. The phase in the remaining interval $[\pi, 2\pi]$ of a full sine wave cycle may be obtained by a symmetry transform performed by the waveform transform unit 130, which will be described later.

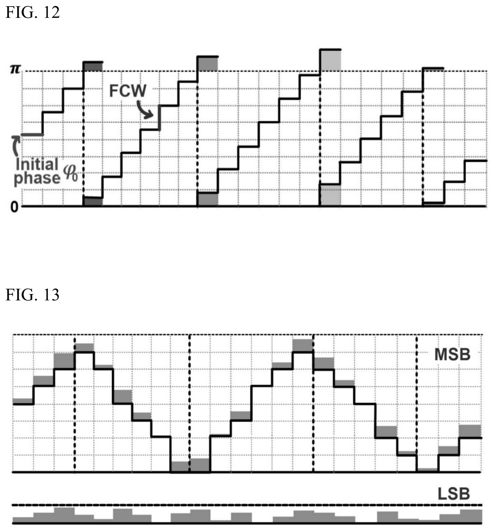

As shown in FIG. 12, the waveform transform unit (triangular transform, T1) 130 receives the repetitive accumulation value from the rotational phase accumulator 120 and performs a symmetry transform on part of the received value. The symmetry transform may include an operation of inverting the repetitive accumulation value at every interleaved period. In this exemplary embodiment, the symmetry transform may be configured to leave the repetitive accumulation value of odd-numbered rising periods as is, and to invert only the repetitive accumulation value of even-numbered rising periods about the midpoint $\pi$ between the maximum and minimum values. Therefore, in even-numbered rising periods of the repetitive accumulation value, the waveform transform unit 130 outputs a waveform that decreases from $\pi$ to 0. That is, the output signal of the rotational phase accumulator 120, which originally resembled a sawtooth wave, may have an overall triangular waveform as a result of the symmetry transform.

Furthermore, as shown in FIG. 13, the waveform transform unit 130, as linear digital data to be converted into an analog signal, may transmit the four leftmost bits (most significant bits, MSBs) of the digital code composed of the symmetry-transformed values to the non-linear differential DAC 230. Additionally, the waveform transform unit 130 may transmit the lower 4 bits (least significant bits, LSBs) of the symmetry-transformed values as residual data signals to the interpolating DAC 250.

In the digital preprocessing unit including the above-described controller 110, clock calculator 112, rotational phase accumulator 120, and waveform transform unit 130, the initial phase value $\varphi_0$ provided from the controller 110 to the rotational phase accumulator 120 may have a bit length of, for example, 14 bits. In this case, the FCW delivered from the controller 110 to the rotational phase accumulator 120 at every clock cycle may have a smaller bit width than the initial phase value. For example, each FCW may have a bit length of 13 bits or less.

Meanwhile, to simplify the configuration of the analog processing unit, in this exemplary embodiment, the rotational phase accumulator 120 may be configured to transmit only the upper 8 bits of the 14-bit repetitive accumulation value to the waveform transform unit 130, and to discard the lower 6 bits. Here, the specific number of bits used by the rotational phase accumulator 120 and waveform transform unit 130 may be referred to as a "valid input signal." The above-described specific bit lengths are illustrative and do not limit the present disclosure.

In the present exemplary embodiment, the extraction of the upper 4 bits among the valid input signal symmetrically transformed by the waveform transform unit 130 as a linear data signal for conversion into an analog signal may be regarded as a result of quantization. The lower 4 bits of the valid input signal, that is, the residual data signal, correspond to the difference between the valid input signal and the linear data signal, and may be interpreted as a residue or error following quantization.

The analog processing unit will now be described in detail with reference to FIG. 9 and FIGS. 14 to 16.

First, the current bias 210 may have a circuit configuration including an on/off switch and a variable current source (also referred to as the first current source), as shown in FIG. 9, FIG. 14, and FIG. 15. The current bias 210 may receive an enable signal for controlling the on/off state of the current bias unit and a control signal of a predetermined bit width for controlling the level of the variable current source from the controller 110. The enable signal may be referred to as an on/off signal applied to the control terminal of the on/off switch, and the control signal may be an 8-bit signal. A current of a predetermined magnitude output from the current bias 210 may be supplied as a current source to the non-linear differential DAC 230.

The non-linear differential DAC 230 may include a plurality of sub-converters connected in parallel, as shown in FIG. 15. The plurality of sub-converters may operate to convert the digital code or binary code of the MSBs of the predetermined bits received from the waveform transform unit 130 into a thermometer code. The thermometer code may, for example, represent a value or number according to the number of ones included in the digital code.

Additionally, the plurality of sub-converters may be configured to supply replica current sources to the interpolating DAC 250 according to the enable signal from the controller 110. The enable signal may be referred to as an interpolating choice signal for selecting the interpolating operation mode of the interpolating DAC 250.

The above-described non-linear differential DAC 230 may include a plurality of sub-converters in the form of differential circuits that separately calculate an in-phase signal (I-signal) and a quadrature signal (Q-signal). Half of the plurality of sub-converters may be in-phase DACs, and the remaining half may be quadrature DACs. The quadrature DACs and the in-phase DACs may have the same configuration and may be arranged to form pairs among the plurality of sub-converters.

In the plurality of sub-converters, each sub-converter may include a first mirror, a second mirror, and a second current source. The first mirror may receive a digital code of the MSBs of the predetermined bits from the waveform transform unit 130. In the present exemplary embodiment, the MSBs digital code may be 4 bits, and the thermometer code may be 16 bits. The second mirror may supply a current source to the interpolating DAC 250 according to the interpolating choice signal. The second current source may be composed of a transistor connected to the first current source and may be configured to determine the current level of each sub-converter according to the level at which the current of the current source of the current bias 210 is distributed.

Each sub-converter may further include sixteen second current sources, each of which has a gate connected to the drain of the first current source of the current bias through which the reference current flows. Each source of the sixteen second current sources is connected to the ground, and each drain is connected to an output terminal or an inverted output terminal through a first switch of the first mirror and a second switch of the second mirror.

The second current sources may correspond to constant current sources capable of supplying currents corresponding to respective levels labeled as $\Delta 1$ to $\Delta 16$. The levels may be referred to as gradations. The levels may correspond to incremental amplitudes of a sine wave for a phase change step of $\pi/16$. In the present exemplary embodiment, the incremental amplitude may differ for each of the second current sources. That is, although the first current source, which is the reference current source, and the sixteen second current sources are connected in a form resembling a current mirror in FIG. 15 and FIG. 16, some or all of the sixteen second current sources may supply different amounts of current. For example, as may be inferred from the density of the auxiliary lines in the horizontal direction in FIG. 13, the second current sources located near the center may supply larger currents than approximately four other second current sources located at either end. This operational characteristic may be achieved by determining the current values of each second current source during the design phase to match a desired nonlinear mapping between linear inputs and nonlinear output characteristics of the non-linear differential DAC 230, and by adjusting the size of the transistors forming the second current sources, for example, by varying the aspect ratio of the channel.

The first terminal of the above-described first switch may be connected to the output terminal of the non-linear differential DAC 230, the second terminal may be connected to the inverted output terminal of the non-linear differential DAC 230, and the common terminal may be connected to the first terminal of the second switch. The second terminal of the second switch may be connected to the input terminal of the interpolating DAC 250, and the common terminal may be connected to the drain of each second current source.

The interpolating DAC 250 may include four transistor pairs, each forming a pass transistor. To the gate of each transistor pair, one bit among the lower 4 bits (LSBs) of the valid input signal after the symmetric transformation, that is, the residual data signal, and its inverted value may be applied. In each transistor pair, the first terminal of the transistor receiving the valid input signal bit at the gate is connected to the inverted output terminal, and the first terminal of the other transistor is connected to the output terminal. The second terminal of each transistor forming the transistor pairs is connected to the output terminal of the interpolating DAC 250. Additionally, the interpolating DAC 250 may be configured such that the second terminal of each transistor is connected to the source of a respective transistor of the second switch, the first terminal of each transistor is connected to the inverted output terminal, and the control terminal of each transistor is connected to a dummy transistor to which a bias voltage (VDD) is applied.

As described above, each of the first switches of the non-linear differential DAC 230 is supplied with each bit of the thermometer code corresponding to the upper 4 bits (MSBs) of the valid input signal after the symmetric transformation, as a switching control signal representing the linear data signal. Each of the first switches is controlled by the corresponding bit of the thermometer code. For example, when the thermometer code has a value of '0000000000000011', two of the second current sources may supply current through the output terminal, thirteen of the second current sources may supply current through the inverted output terminal, and the remaining one second current source may supply current divided between the output terminal and the inverted output terminal via the interpolating DAC 250.

That is, the interpolating DAC 250 may perform non-linear sine mapping, as shown in FIG. 16. The non-linear sine mapping converts a digital code, expressed as the sum of a non-linear MSB and a linear interpolated LSB, into an analog signal through digital-to-analog conversion. For example, the interpolating DAC 250 may output an interpolated value through a pass transistor structure of four transistor pairs based on the 4-bit LSBs received from the waveform transform unit 130. The interpolated value output by the interpolating DAC 250 may be added to the output value of the non-linear differential DAC 230. This interpolating operation by at least one interpolated value, as a non-linear sine mapping, may function to partially fill in between two MSB values sequentially output from adjacent sub-converters among the plurality of sub-converters of the non-linear differential DAC 230.

In other words, the interpolating DAC 230a compensates the output resolution of the non-linear differential DAC 230 by interpolating the output current. For example, in generating the waveform shown in FIG. 16, assuming that only two of the second current sources are connected to the output terminal and flow a current equal to the sum of the currents supplied by the two second current sources, i.e., $\Delta 1 + \Delta 2$, a considerable error would exist between the current amount to be generated and the actual current amount. In this case, considering only the corresponding section, interpolation may be performed under the assumption that the current variation does not significantly deviate from a linear trend over time, as represented by the second term on the right-hand side of Equation 7.

The total signals (outputs) output from the interpolating DAC 250 for the non-linear sine mapping may be expressed by the following Equation 4.

【Equation 4】

$$Output = \sum_{i=1}^{n-1} \Delta i + \frac{a}{16} \times (\Delta n)$$

In Equation 4, 'n' represents the MSB code, 'a' represents the LSB code, and '16' represents the sum of the MSB and LSB bits. In addition, the first term on the right-hand side of Equation 4 represents the non-linear values ($\Delta 1$ through $\Delta 16$) that may be sequentially expressed in a predetermined curved form between 0 and $\pi$, and the second term on the right-hand side represents interpolating values filled between the non-linear values.

The above-described interpolating DAC 250 may output the current flowing through each transistor pair and the dummy transistor according to the residual data signal through the output node of the corresponding circuit. The output node of the interpolating DAC 250 may be connected to only one of the second current sources of the non-linear differential DAC 230. The second current source connected to the output node of the interpolating DAC 250 is a current source (hereinafter referred to as a 'third current source') corresponding to the least significant bit having a bit value of '0' in the thermometer code. According to this configuration, the currents flowing through the transistor pairs and the dummy transistor of the interpolating DAC 250 flow through the third current source, and the current flowing through the third current source is divided to interpolate the output current of the non-linear differential DAC 230.

When such interpolation is used, in the region where the sinusoidal waveform changes most rapidly, the change in slope is not large, so the error caused by the linear interpolation method is not significant. Meanwhile, in the region where the slope change is the greatest, the actual output variation is small, and thus the resulting error is also not significant. Therefore, by using the non-linear differential DAC 230 in combination with the interpolating DAC 250, high resolution may be obtained with a minimum number of input bits, and advantages may also be achieved in terms of operation speed. Furthermore, since the interpolating DAC 250 operates only on a certain section or stage among the second current sources of the non-linear differential DAC 230, the interpolation circuit does not substantially increase the complexity of the overall device structure, and the effect of system complexity on operation speed is negligible or almost nonexistent.

According to the above-described configuration, in the drain signal generation device, pulses generated by two of the four frequency generators (see 310, 320, 330, and 340 in FIGS. 6, 7, and 8) of the driver 100 may be added and interpolated by the addition circuit 260.

The main pulse interpolated as described above may be expressed by the following Equation 5.

【Equation 5】

$$O_{main}(t) = O_{on}(t)\sin(\omega_w t)\cos(\omega_{01}t + \varphi)$$

$$= O_{on}(t)\frac{1}{2}\{\sin[(\omega_{01} + \omega_w)t + \varphi] - \sin[(\omega_{01} - \omega_w)t + \varphi]\}$$

In Equation 5, $\varphi$ is a value determined by the FCW and may be arbitrarily set for each qubit control signal output from one driver 100.

Among the four frequency generators of the above-described driver 100, the pulses generated by the remaining two frequency generators may be interpolated by the addition circuit 260.

The DRAG pulse interpolated as described above may be expressed by the following Equation 6.

【Equation 6】

$$O_{DRAG}(t) = O_{on}(t)q_{scale}\cos(\omega_w t)\sin(\omega_{01}t + \varphi)$$

$$= O_{on}(t)q_{scale}\frac{1}{2}\{\sin[(\omega_{01} + \omega_w)t + \varphi] + \sin[(\omega_{01} - \omega_w)t + \varphi]\}$$

In Equation 6, the scale factor $q_{scale}$ may be determined according to the current level of the current bias 210.

The qubit control signal generated by the four frequency generators of the above-described driver 100 may be expressed by the following Equation 7.

【Equation 7】

$$O(t) = O_{on}(t)\frac{1}{2}\{\sin[(\omega_{01} + \omega_w)t + \varphi] - \sin[(\omega_{01} - \omega_w)t + \varphi]\}$$

$$+ q_{scale}\{\sin[(\omega_{01} + \omega_w)t + \varphi] + \sin[(\omega_{01} - \omega_w)t + \varphi]\}$$

As described above, according to the present exemplary embodiment, the qubit control signal may be generated without memory by using the four frequency generators of the driver 100.

The waveform shaping circuit 350 may shape the analog signals output from the four frequency generators for better spectral separation between pulses. In this exemplary embodiment, the waveform shaping circuit 350 may perform shunt-based amplitude waveform shaping that approximates the LO frequency of a phase-locked loop to simplify circuit implementation. The waveform shaping circuit 350 may include capacitors and transistors connected in parallel to convert the output signal between the I-signal output terminal and the inverted output terminal into a raised cosine shape.

The mixer 370 is connected to the I-signal output terminal and the inverted output terminal, as well as to the Q-signal output terminal and the inverted output terminal of the analog processing unit. Between the I-signal output terminal and the inverted I-signal output terminal, transistor pairs for mixing the LO signal are disposed. Similarly, transistor pairs for mixing the LO signal are disposed between the Q-signal output terminal and the inverted Q-signal output terminal. The transistor pairs may frequency-modulate the LO signal based on the output signal from the analog processing unit, and deliver a nonlinear high-frequency signal to the output circuit 390.

By using the mixer 370, the gap between the I-signal and the inverted I-signal may be reduced, and as the magnitude of the I-signal decreases, the envelope of the waveform-shaped signal output from the waveform shaping circuit 350 repeatedly narrows and widens.

The output circuit 390 may filter the waveform-shaped analog signal and output an output voltage, which is the radio frequency output (RF OUT), as the nonlinear waveform signal, i.e., the qubit control signal. The output circuit 390 includes a primary winding and a secondary winding that are magnetically coupled. The inductors of the primary winding and a variable capacitor may form a filter that removes unwanted sidebands of the local oscillation signal and allows only the desired sideband to pass.

In the example of the illustrated circuit (see FIG. 9), the center tap of the primary winding is supplied with a bias voltage (VDD), which may be configured to bias the second current sources of the nonlinear differential DAC 230 through the I-signal and Q-signal output terminals and the inverted output terminals. Meanwhile, in this exemplary embodiment, instead of the magnetically coupled primary and secondary windings, a resistor may be disposed, and the voltage drop across both ends of the resistor may be used as the output voltage.

According to the above-described qubit control signal generation apparatus, the main pulse and DRAG pulse may be generated without memory by using four independent frequency generators, and a qubit control signal, which is a combination of the main pulse and DRAG pulse, may be generated. This allows the complete generation of the qubit control signal in a cryogenic superconducting computing device without memory, enabling low-power operation and effective scalability of the number of qubit control signals as the number of qubits increases.

In particular, the importance of operating without memory and with low power lies in the specificity of superconducting quantum computers. Superconducting quantum computers operate at cryogenic temperatures of approximately 10 mK and therefore require a cryogenic refrigeration device. Consequently, when RF signals for qubit control are generated externally, they must be supplied into the refrigeration device as high-speed RF signals. Since these RF signals increase in proportion to the number of qubits, they must be connected via thousands to tens of thousands of physical channels or cables, which is extremely inefficient in practice. Therefore, research is being conducted to generate the qubit control signal within the 4 K region of the refrigeration device and control the qubits under the constraint that the control chip must operate within the limited cooling power of the 4 K region. However, in existing methods proposed thus far, a large number of DRAG pulses for qubit control could not be generated in the 4 K region. In contrast, according to the method and apparatus of the present exemplary embodiment, main pulses, DRAG pulses, or qubit control signals combining the main and DRAG pulses for controlling a large number of qubits may be simply and effectively generated without memory.

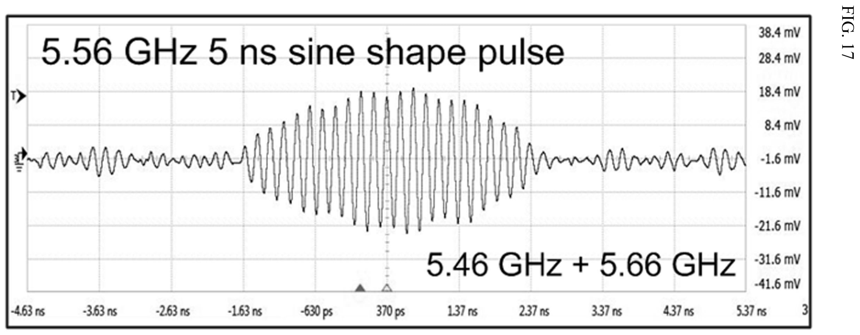

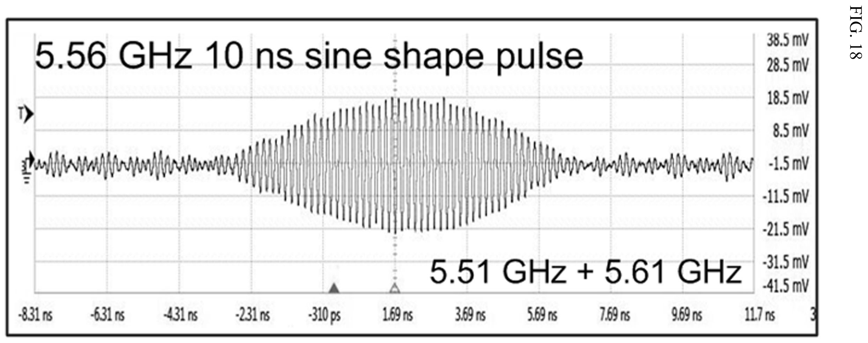

FIG. 17 is a graph showing a sine-shaped pulse of 5.56 GHz and 5 ns measured at 4 K using a chip implementing the qubit control signal generation apparatus of FIG. 9. FIG. 18 is a graph showing a sine-shaped pulse of 5.56 GHz and 10 ns generated using an intermediate frequency of ±50 MHz based on the sine-shaped pulse of FIG. 17.

As shown in FIG. 17, the DRAG signal generation apparatus may generate a 5 ns sine-shaped pulse as a main pulse using two frequency generators that respectively generate frequencies of 5.56 GHz + 100 MHz and 5.56 GHz - 100 MHz through a local oscillator (LO) of a phase-locked loop with a frequency of 5.66 GHz.

Also, as shown in FIG. 18, the DRAG signal generation apparatus may generate a 10 ns sine-shaped pulse as a main pulse using two frequency generators that respectively generate frequencies of 5.56 GHz + 50 MHz and 5.56 GHz - 50 MHz through a local oscillator (LO) of a phase-locked loop generating a 5.66 GHz frequency signal.

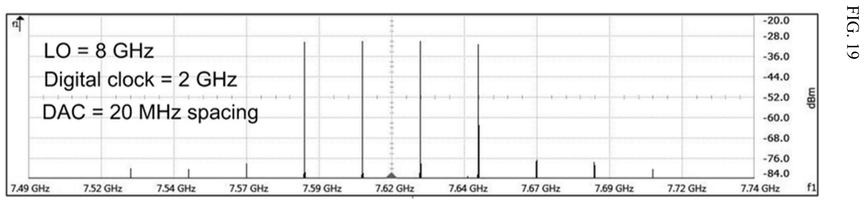

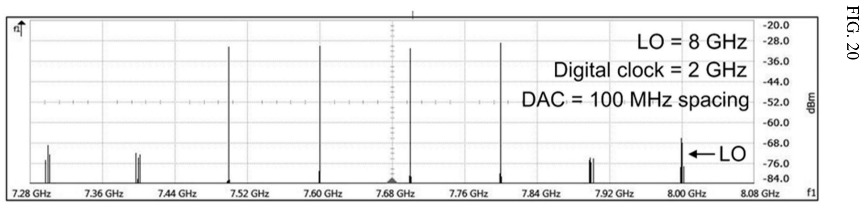

FIG. 19 is a graph showing the result of generating signals having multiple frequency components at 20 MHz intervals by independently generating frequency and phase signals at each of the four frequency generators of the qubit control signal generation apparatus of FIG. 9. FIG. 20 is a graph showing the result of generating signals having multiple frequency components at 100 MHz intervals by independently generating frequency and phase signals at each of the four frequency generators of the qubit control signal generation apparatus of FIG. 9.

As shown in FIG. 19, it may be confirmed that the qubit control signal generation apparatus of the present exemplary embodiment may generate four tones of qubit control signals simultaneously. The readout radio frequency signal from the qubit control signal generation apparatus may have the characteristics of an 8 GHz LO frequency, a 2 GHz digital clock, 20 MHz DAC spacing, and a center frequency of 7.62 GHz.

As also shown in FIG. 20, it may be confirmed that the qubit control signal generation apparatus according to the present exemplary embodiment is capable of generating four tones of qubit control signals simultaneously. The readout radio frequency signal from the qubit control signal generation apparatus may have characteristics of an 8 GHz LO frequency, a 2 GHz digital clock, and 100 MHz DAC spacing.

As such, each of the four frequency generators may operate simultaneously and independently.

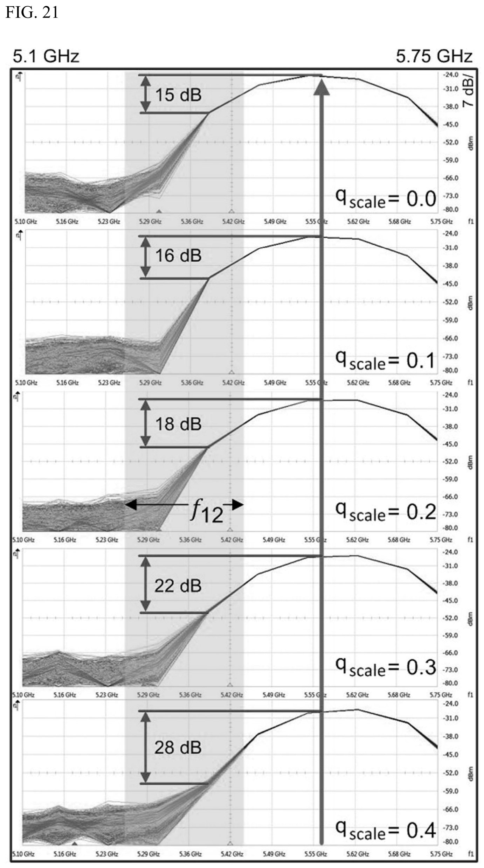

FIGS. 21 through 23 are graphs showing the results of operating the qubit control signal generation apparatus of FIG. 9 at 4 K and measuring the frequency spectrum distribution while adjusting the frequency and phase of the four frequency generators to match a desired DRAG pulse and varying the scale factor qscale.

As shown in FIG. 21, the qubit control signal generation apparatus may generate a DRAG pulse having an output frequency of 5.46 GHz, a pulse width of 5 ns, and leakage suppression of the second frequency component $f_{12}$ of at least 15 dB, using a LO frequency of 5.56 GHz, the first and third frequency generators using 5.46 GHz + 20 MHz, and the second and fourth frequency generators using 5.46 GHz - 20 MHz. As the scale factor qscale varies-i.e., not applied (0.0), and applied as 0.1 through 0.4-the resulting leakage suppression of $f_{12}$ is 15 dB, 16 dB, 18 dB, 22 dB, and 28 dB, respectively.

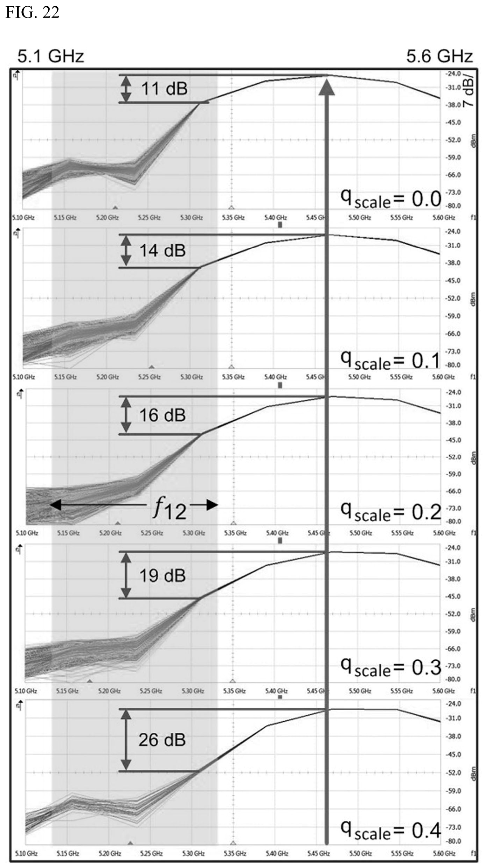

As shown in FIG. 22, the apparatus may generate a DRAG pulse with an output frequency of 5.46 GHz, a pulse width of 10 ns, and $f_{12}$ leakage suppression of at least 11 dB, using the first and third frequency generators at 5.46 GHz + 50 MHz, and the second and fourth at 5.46 GHz - 50 MHz. With scale factors of 0.0 through 0.4, the suppression values are 11 dB, 14 dB, 16 dB, 19 dB, and 26 dB, respectively.

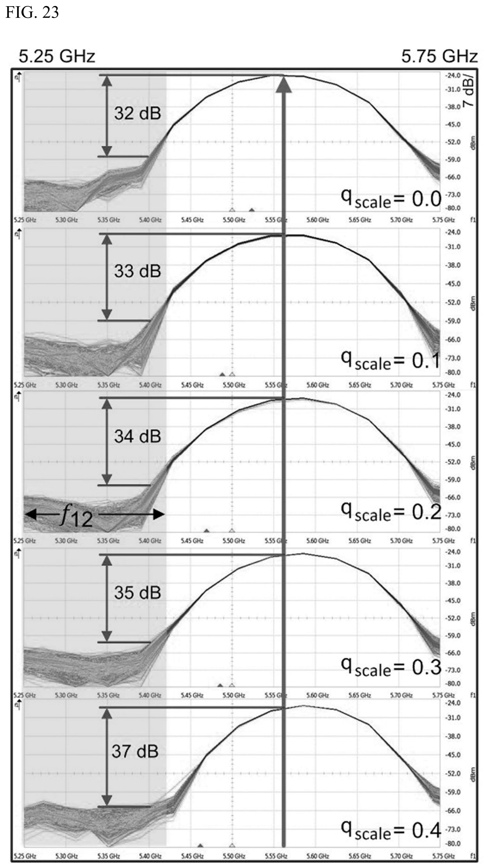

As shown in FIG. 23, the apparatus may generate a DRAG pulse with output frequency 5.56 GHz, pulse width 15 ns, and $f_{12}$ leakage suppression of at least 32 dB, using 5.56 GHz + 33 MHz and 5.56 GHz - 33 MHz in the respective generator pairs. The resulting leakage suppression, for qscale from 0.0 to 0.4, is 32 dB, 33 dB, 34 dB, 35 dB, and 37 dB.

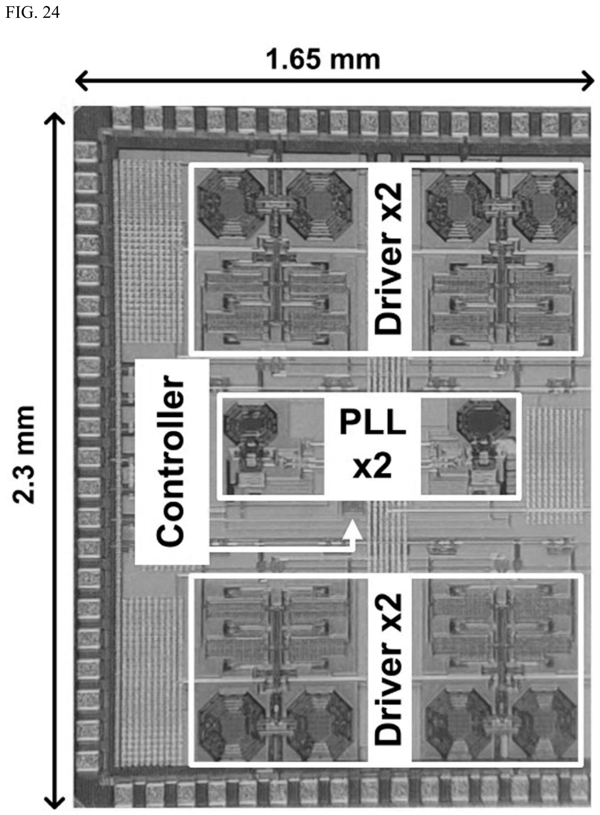

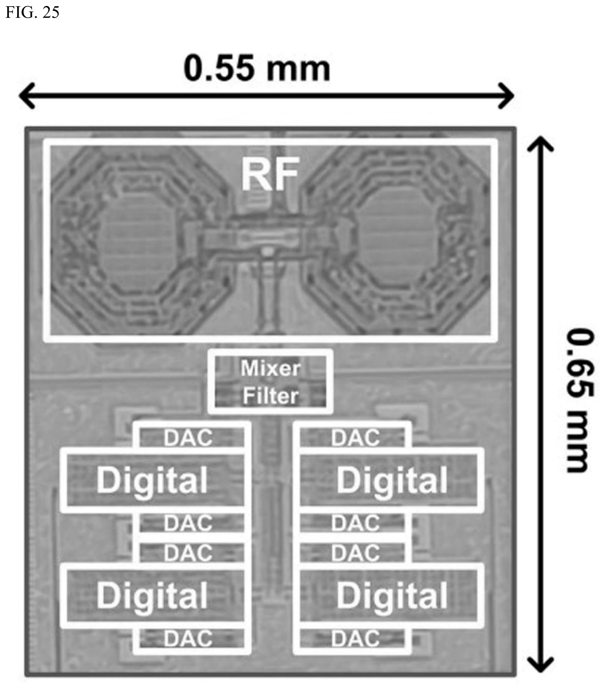

FIG. 24 is a microscope image of a chip implementing the qubit control signal generation apparatus according to the present exemplary embodiment. FIG. 25 is a magnified view of the frequency generator portion in FIG. 24.

As shown in FIG. 24, each frequency generator of the apparatus may be implemented in the form of an integrated circuit (IC) including a controller, two phase-locked loops (PLLs), and four drivers. The IC may measure 1.65 mm by 2.3 mm. As shown in FIG. 25, each driver may be fabricated using a 40 nm bulk CMOS process and may measure 0.55 mm by 0.65 mm. The driver may comprise a controller, clock calculator, repetitive phase accumulator, and four digital parts for waveform conversion, a plurality of DACs including a nonlinear differential DAC and interpolation DAC, a filter for waveform shaping, a mixer, and an RF output stage.

According to the above configuration, DRAG-based qubit control pulses for superconducting qubits may be efficiently synthesized using four sinusoidal signals. No memory or LUT (lookup table) is required to generate the qubit control pulses. Moreover, it is demonstrated that four-channel qubit control pulses may be generated simultaneously for frequency-division multiplexing (FDM). In readout pulse generation mode, a power consumption of 7.2 mW per qubit was confirmed, indicating suitability for low-power quantum computers.

As such, without using memory-i.e., without additional components for amplitude variation-sine-shaped or raised cosine-shaped main pulses may be generated, and similarly, DRAG pulses may be generated in a low-power manner without memory. In addition, four independent intermediate-frequency signals may be generated using frequency generators to simultaneously read out signals from four qubits in a low-power configuration. That is, a method and apparatus are provided for generating four different frequency signals simultaneously.

Furthermore, since an internal PLL is used to generate the LO frequency, the frequency generated by the PLL may be divided, for example by 1/8 or 1/16, to be used as a digital system clock. This configuration enables precise phase alignment of intermediate-frequency (IF) signals generated using the LO signal and the digital block.

Moreover, considering that phase errors may occur due to clock delay when using the same system clock across multiple frequency generators, phase alignment may be compensated during internal frequency generation by adding a phase offset, thereby improving the reliability and stability of device operation.

In a narrower sense, the qubit control signal generation apparatus may be centered around two frequency generators used to generate a DRAG signal, in which case the apparatus may be referred to as a DRAG signal generation apparatus.

While the present disclosure has been described with reference to preferred embodiments, it will be understood by those skilled in the art that various modifications and changes may be made without departing from the spirit and scope of the invention as defined in the appended claims.

**Claims**

1. A method for generating a qubit control signal for controlling a quantum computer, comprising:

   generating a first sine wave having a first phase obtained by multiplying an angular frequency, which is a sum of a first angular frequency corresponding to a center frequency and a second angular frequency corresponding to a frequency located to the left of the center frequency, by an arbitrary time of each cycle; and
   generating a second sine wave having a second phase obtained by multiplying an angular frequency, which is a difference between the first angular frequency and the second angular frequency, by the arbitrary time;
   wherein a DRAG (derivative removal by adiabatic gate) pulse for the qubit control signal is generated through an addition operation of the first and second sine waves.

2. The method of claim 1, further comprising:

   generating a third sine wave having a third phase obtained by multiplying an angular frequency, which is a sum of the first angular frequency and the second angular frequency, by the arbitrary time; and
   generating a fourth sine wave having a fourth phase obtained by multiplying an angular frequency, which is a difference between the first angular frequency and the second angular frequency, by the arbitrary time;
   wherein a main pulse of the qubit control signal is generated through a subtraction operation between the third and fourth sine waves.

3. The method of claim 2, further comprising:
   setting a current bias of the first and second sine waves such that a scale factor is multiplied to the DRAG pulse.

4. The method of claim 3, wherein the scale factor is any real value selected from a range of 0 or more and less than 1.

5. The method of claim 3, further comprising:
   wave-shaping the first to fourth sine waves together so as to synthesize the main pulse and the DRAG pulse to generate a qubit control pulse.

6. The method of claim 5, further comprising:
   converting the qubit control pulse into a radio frequency output signal by adding a main frequency of a phase-locked loop according to a plurality of phase signals applied to a mixer.

7. The method of claim 2, further comprising:
   specifying an initial phase for generating each of the first to fourth sine waves.

8. The method of claim 2, wherein each of the generating of the first to fourth sine waves comprises:

repetitively accumulating a frequency codeword (FCW) within a range from zero to a preset upper limit from a predetermined initial phase;
inverting even-numbered rising cycles of accumulated values obtained in the accumulating of the FCW to convert the accumulated values into a sine waveform;
converting preset upper bits of sine waveform-converted accumulated values into a first analog signal;
converting preset lower bits of the sine waveform-converted accumulated values into a second analog signal; and
interpolating the first analog signal by adding the second analog signal to the first analog signal.

9. The method of claim 2, further comprising:
synchronizing processing timing of data or signals input to four controllers, each of supplies with a phase signal and a frequency codeword (FCW) for determining an initial phase of each of the first to fourth phases, by four clock calculators coupled to the controllers, respectively.

10. The method of claim 9, further comprising:
delivering, to each of the four clock calculators, some of the sub-clocks obtained by dividing a reference clock supplied from outside the qubit control signal generator into n sub-clocks, where n is 8 or 16.

11. The method of claim 10, further comprising:

determining a first main frequency according to the reference clock to generate a first phase signal and a first clock signal based on the first main frequency;
determining a second main frequency, different from the first main frequency, according to the reference clock to generate a second phase signal and a second clock signal based on the second main frequency; and
selecting one of the first phase signal and the second phase signal to supply the selected one to first to fourth frequency generators to respectively generate the first to fourth sine waves.

12. The method of claim 9, further comprising:
distributing data and control signals input from outside to the four controllers by a main controller connected to the four controllers.

13. A qubit control signal generation apparatus for quantum computer control, comprising:

a first frequency generator configured to generate a first sine wave having a first phase obtained by multiplying an angular frequency, which is a sum of a first angular frequency corresponding to a center frequency and a second angular frequency corresponding to a frequency located to the left of the center frequency, by an arbitrary time of each cycle; and
a second frequency generator configured to generate a second sine wave having a second phase obtained by multiplying an angular frequency, which is a difference between the first angular frequency and the second angular frequency, by the arbitrary time;
wherein a DRAG (derivative removal by adiabatic gate) pulse for a qubit control signal is generated through an addition process of the first and second sine waves.

14. The apparatus of claim 13, further comprising:

a third frequency generator configured to generate a third sine wave having a third phase obtained by multiplying an angular frequency, which is a sum of the first angular frequency and the second angular frequency, by the arbitrary time; and
a fourth frequency generator configured to generate a fourth sine wave having a fourth phase obtained by multiplying an angular frequency, which is a difference between the first angular frequency and the second angular frequency, by the arbitrary time;
wherein a main pulse for the qubit control signal is generated through a subtraction process of the fourth sine wave from the third sine wave.

15. The apparatus of claim 14, wherein, to generate a qubit control pulse in which a main pulse corresponding to a first term on the right-hand side of following equation and a DRAG pulse corresponding to a second term on the right-hand side are synthesized from the first to fourth sine waves, the device performs a subtraction operation of the fourth sine wave from the third sine wave, and an addition operation of the first and second sine waves for synthesis,

$$O(t) = O_{on}(t)\frac{1}{2}\{\sin[(\omega_{01} + \omega_w)t] - \sin[(\omega_{01} - \omega_w)t]\}$$

$$+q_{scale}\{\sin[(\omega_{01} + \omega_w)t] + \sin[(\omega_{01} - \omega_w)t]\}$$

wherein, $O(t)$ denotes the qubit control pulse, $O_{on}(t)$ denotes an on-time pulse of a frequency generation circuit, $q_{scale}$ denotes a scale factor, $\omega_{01}$ denotes a phase angle at an arbitrary time t of a qubit ground state, and $\omega_w$ denotes a phase angle of the qubit at arbitrary time t.

16. The apparatus of claim 15, further comprising:
a mixer configured to convert the qubit control pulse into a radio frequency output signal by adding the main frequency of a phase-locked loop to the qubit control pulse in accordance with a plurality of phase signals of the phase-locked loop.

17. The apparatus of claim 15, wherein the third and fourth frequency generators respectively comprise third and fourth current biases for supplying reference-level power for operation of the third and fourth frequency generators; and the first and second frequency generators respectively comprise first and second current biases for supplying a power level obtained by multiplying the reference level by a scale factor for the operation of the first and second frequency generators.

18. The apparatus of claim 14, wherein each of the first to fourth frequency generators comprises:

a controller configured to output a frequency codeword (FCW), a phase signal specifying an initial phase, and an enable signal;
a repetitive phase accumulator configured to repetitively accumulate the frequency codeword from an initial phase determined by the phase signal within a range from zero to a preset upper limit;
a waveform converter configured to convert the repetitively accumulated values into a triangular or sine waveform by inverting even-numbered rising cycles;
a nonlinear differential digital-to-analog converter (DAC) configured to convert upper bits of the sine waveform-converted values into a first analog signal;
an interpolation DAC configured to convert lower bits of the sine waveform-converted values into a second analog signal; and
an adder configured to interpolate the first analog signal by adding the second analog signal to the first analog signal.

19. The apparatus of claim 18, wherein each of the first to fourth frequency generators further comprises a clock calculator configured to align the processing timing of data or control signals input to the controller.

20. The apparatus of claim 18, further comprising:

a first phase-locked loop (PLL) configured to determine a first main frequency based on a reference clock and generate a first phase signal and a first clock signal based on the first main frequency;
a second phase-locked loop configured to determine a second main frequency different from the first main frequency based on the reference clock and generate a second phase signal and a second clock signal based on the second main frequency;
a clock selector configured to select one of the first and second phase signals and provide the selected phase signal to the first to fourth frequency generators; and
a main controller connected to four controllers of the first to fourth frequency generators, configured to distribute data and control signals input from outside a dilution refrigerator to the four controllers.

FIG. 1

10

12

$| 2 \rangle$

$| 1 \rangle$

$| 0 \rangle$

E2

E1

FIG. 2

10 ns width

Power spectrum (dB)

Rectangle
Gaussian ($\sigma$=3n)
Raised-cosine
Sine

10

0

-10

-20

-30

-40

-50

-60

-1.0

$f_{12}$

$f_{01}$

1.0

Frequency (GHz)

FIG. 3

FIG. 4

FIG. 5

$O_{on}(t)$

FIG. 6

FIG. 7

FIG. 8

FIG. 9

FIG. 10

FIG. 11

FIG. 12

FIG. 13

FIG. 14

FIG. 15

EP 4 742 112 A1

32

FIG. 16

Non-linear sine mapping

FIG. 17

FIG. 18

FIG. 19

FIG. 20

FIG. 21

FIG. 22

FIG. 23

FIG. 24

FIG. 25

## INTERNATIONAL SEARCH REPORT

| International application No. |
| --- |
| **PCT/KR2023/019671** |

| | |
| --- | --- |
| **A. CLASSIFICATION OF SUBJECT MATTER** | |
| **G06N 10/40**(2022.01)i; **H03K 3/80**(2006.01)i; **B82Y 10/00**(2011.01)n | |
| According to International Patent Classification (IPC) or to both national classification and IPC | |

**B. FIELDS SEARCHED**

Minimum documentation searched (classification system followed by classification symbols)

G06N 10/40(2022.01); H03K 17/92(2006.01); H03K 3/38(2006.01); H03L 7/099(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 큐비트(qubit), 양자(quantum), 제어 신호(control signal), 생성(generation), DRAG(derivative removal by adiabatic gate), 펄스(pulse), 주파수(frequency)

**C. DOCUMENTS CONSIDERED TO BE RELEVANT**

| Category* | Citation of document, with indication, where appropriate, of the relevant passages | Relevant to claim No. |
| --- | --- | --- |
| A | DE, Amrit. Fast Quantum Control for Weakly Nonlinear Qubits: On Two-Quadrature Adiabatic Gates. arXiv:1509.07905v1. September 2015. [Retrieved on 13 March 2024]. Retrieved from <URL: https://arxiv.org/abs/1509.07905v1>.<br>See pages 1-7. | 1-20 |
| A | US 10560076 B1 (QUANTUM MACHINES) 11 February 2020 (2020-02-11)<br>See column 3, line 24 – column 12, line 57. | 1-20 |
| A | US 2022-0045666 A1 (QUANTUM MACHINES) 10 February 2022 (2022-02-10)<br>See paragraphs [0025]-[0071]. | 1-20 |
| A | US 11658660 B1 (INTERNATIONAL BUSINESS MACHINES CORPORATION) 23 May 2023 (2023-05-23)<br>See claims 1-8. | 1-20 |
| A | DE, Amrit. Fast two-quadrature adiabatic quantum gates for weakly nonlinear qubits: a tight-binding approach. Quantum Information Processing (2019). Vol. 18, No. 165, 19 April 2019.<br>See pages 3-17. | 1-20 |

| ✓ Further documents are listed in the continuation of Box C. | ✓ See patent family annex. |
| --- | --- |

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **22 March 2024** | **22 March 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
| --- |
| **PCT/KR2023/019671** |

### C. DOCUMENTS CONSIDERED TO BE RELEVANT

| Category* | Citation of document, with indication, where appropriate, of the relevant passages | Relevant to claim No. |
| --- | --- | --- |
| X | KANG, Kiseo et al. A Cryogenic Controller IC for Superconducting Qubits with DRAG Pulse Generation by Direct Synthesis without Using Memory. 2023 IEEE International Solid-State Circuits Conference (ISSCC). 19 February 2023.<br>See entire document.<br><br>※ This document is a known document declaring exceptions to lack of novelty by the applicant. | 1-20 |

Form PCT/ISA/210 (second sheet) (July 2022)

**INTERNATIONAL SEARCH REPORT**
Information on patent family members

International application No.

**PCT/KR2023/019671**

| Patent document cited in search report | | | Publication date (day/month/year) | Patent family member(s) | | | Publication date (day/month/year) |
|---|---|---|---|---|---|---|---|
| US | 10560076 | B1 | 11 February 2020 | CN | 114207630 | A | 18 March 2022 |
| | | | | EP | 4004834 | A1 | 01 June 2022 |
| | | | | US | 10931267 | B1 | 23 February 2021 |
| | | | | US | 11387820 | B2 | 12 July 2022 |
| | | | | US | 2021-0036692 | A1 | 04 February 2021 |
| | | | | US | 2021-0143805 | A1 | 13 May 2021 |
| | | | | US | 2023-0123630 | A1 | 20 April 2023 |
| | | | | WO | 2021-019294 | A1 | 04 February 2021 |
| US | 2022-0045666 | A1 | 10 February 2022 | US | 11043939 | B1 | 22 June 2021 |
| | | | | US | 11405024 | B2 | 02 August 2022 |
| | | | | US | 2022-0345120 | A1 | 27 October 2022 |
| | | | | WO | 2022-029526 | A1 | 10 February 2022 |
| US | 11658660 | B1 | 23 May 2023 | WO | 2023-247668 | A1 | 28 December 2023 |

Form PCT/ISA/210 (patent family annex) (July 2022)